(19) **Europäisches Patentamt**
**European Patent Office**
**Office européen des brevets**

(11) **EP 3 355 337 B1**

(12) **EUROPEAN PATENT SPECIFICATION**

(45) Date of publication and mention
of the grant of the patent:
**06.03.2024 Bulletin 2024/10**

(21) Application number: **18153340.7**

(22) Date of filing: **25.01.2018**

(51) International Patent Classification (IPC):
**H01J 37/317** (2006.01)   **H01J 37/302** (2006.01)

(52) Cooperative Patent Classification (CPC):
**H01J 37/3177; H01J 37/3026;** H01J 2237/31764;
H01J 2237/31766

(54) **ADVANCED DOSE-LEVEL QUANTIZATION FOR MULTIBEAM-WRITERS**

ERWEITERTE QUANTISIERUNG AUF DOSISEBENE FÜR MEHRSTRAHLSCHREIBER

QUANTIFICATION DE DOSAGE AVANCÉE POUR DISPOSITIFS D'ÉCRITURE MULTI-FAISCEAUX

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **27.01.2017 EP 17153506**

(43) Date of publication of application:
**01.08.2018 Bulletin 2018/31**

(73) Proprietor: **IMS Nanofabrication GmbH**
**1020 Wien (AT)**

(72) Inventors:
• **Platzgummer, Elmar**
**1090 Wien (AT)**
• **Spengler, Christoph**
**1150 Wien (AT)**
• **Petsch, Hanns Peter**
**1220 Wien (AT)**

(74) Representative: **Patentanwaltskanzlei**
**Matschnig & Forsthuber OG**
**Biberstraße 22**
**Postfach 36**
**1010 Wien (AT)**

(56) References cited:
**US-A1- 2015 028 230**   **US-A1- 2015 347 660**
**US-A1- 2016 013 019**   **US-A1- 2016 071 684**
**US-A1- 2016 276 132**   **US-A1- 2016 336 147**
**US-B2- 8 378 320**

• **Anonymous: "Dither - Wikipedia", , 26 January
2017 (2017-01-26), XP055412751, Retrieved from
the Internet:
URL:https://en.wikipedia.org/w/index.php?t
itle=Dither&oldid=762118152 [retrieved on
2017-10-05]**
• **Anonymous: "Ordered dithering - Wikipedia", ,
13 January 2017 (2017-01-13), XP055412752,
Retrieved from the Internet:
URL:https://en.wikipedia.org/w/index.php?t
itle=Ordered_dithering&oldid=759840417
[retrieved on 2017-10-05]**

**Description**

Field of the invention and description of prior art

The invention relates to a method for irradiating a target with a beam of energetic radiation formed by electrically charged particles for writing a desired pattern on said target, comprising the steps of

- providing a pattern definition device having a plurality of apertures transparent to said radiation,
- illuminating said pattern definition device by means of an illuminating wide beam, which traverses the pattern definition device through said apertures thus forming a patterned beam consisting of a corresponding plurality of beamlets,
- forming said patterned beam into a pattern image on the location of the target, said pattern image comprising the images of at least part of the plurality of apertures covering a number of pattern pixels i.e. aperture image positions, on the target, wherein during a sequence of exposure intervals, each of the apertures is selectively controlled so as to impart respective dose amounts to the pattern pixels onto which the respective aperture is imaged, said dose amounts being selected in accordance with the desired pattern such that each pixel is associated with a nominal dose amount (y) in accordance with the desired pattern,
- generating a relative movement between said target and the pattern definition device producing a stepwise movement of said pattern image on the target along a path over a region where a beam exposure is to be performed, said path being composed of sections which extend along a scanning direction, said sections corresponding to exposure stripes covering said region in sequential exposures.

Methods of the above-described type and charged-particle multi-beam processing apparatuses employing such methods are well-known in prior art. In particular, the applicant has realized charged-particle multi-beam devices as described in several patents in the name of the applicant with respect to the charged-particle optics, pattern definition (PD) device, and multi-beam writing methods employed therein. For instance, a 50 keV electron multi-beam writer which allows to realize leading-edge complex photomasks for 193nm immersion lithograph, of masks for EUV lithography and of templates (1x masks) for imprint lithography, has been implemented, called eMET (electron Mask Exposure Tool) or MBMW (multi-beam mask writer), for exposing 6" mask blank substrates. Moreover, a multi-beam system also referred to as PML2 (Projection Mask-Less Lithography) was implemented for electron beam direct write (EBDW) applications on Silicon wafer substrates. Multi-beam processing apparatuses of the said kind are hereinafter referred to as multi-beam writer, or short MBW.

As a typical implementation of an MBW, the applicant has realized a 50 keV electron writer tool implementing a total beam size of 20 nm comprising 512 $\times$ 512 (= 262,144) programmable beamlets within a beam array field of dimensions 81.92 $\mu$m $\times$ 81.92 $\mu$m at the substrate. In this system, which is referred to as "MBMW tool" hereinafter, the substrate is, typically, a 6" mask blank (having an area of 6" $\times$ 6" = 152.4 mm $\times$ 152.4 mm and thickness 6"/4 = 6.35 mm) covered with an electron beam sensitive resist; furthermore, multi-beam writing is possible on resist-covered 150 mm Si wafers as well.

The current density of a typical MBW, such as the MBMW tool, is no higher than 1 A/cm$^2$ when using 20nm beam size. Thus, when all programmable 262,144 beamlets are "on" the maximum current is 1.05 $\mu$A. In this implementation the 1 sigma blur of the MBW column is approx. 5 nm, as verified experimentally.

There is the possibility to change the beam size, e.g., from 20 nm to 10 nm. For a column with 200:1 reduction this is straightforward by using a different aperture array plate (AAP), with 2 $\mu$m $\times$ 2 $\mu$m opening size of the apertures instead of 4 $\mu$m $\times$ 4 $\mu$m opening size. As outlined in US 8,546,767 of the applicant, a change of the beam size may also be realized in-situ by spatial adjustment of the AAP having multiple aperture arrays of different geometric parameters, such a total size, aperture spacing, aperture shapes etc.

When using a 10 nm beam size and providing a current density at the substrate of no higher than 4 A/cm$^2$, the current of 262,144 programmable beamlets (with all beamlets "on") is again 1.05 $\mu$A at maximum. Thus, also in this case there is virtually no change of the 1 sigma blur of the column with current through the column.

The first generation MBW production machines are targeted to use 20nm and 10nm beams providing up to approx. 1 $\mu$A current for all 262,144 programmable beams "on". For following generations of MBW production machines there is the plan to use even smaller beam size, for instance of 8 nm, and concurrently to provide e.g. 640 $\times$ 640 = 409,600 beamlets within the 81.92 $\mu$m $\times$ 81.92 $\mu$m beam array field at the substrate. Keeping the maximum current density at 4 A/cm$^2$ will ensure that the maximum current (with all beamlets "on") is 1.05 $\mu$A. For instance, using a 5 nm beam size allows providing e.g. 1024 $\times$ 1024 = 1,048,576 programmable beams within the mentioned beam array field at the substrate; again, at a maximum current density of 4 A/cm$^2$ the maximum current (with all beamlets "on") is 1.05 $\mu$A.

For industrial applications, very demanding MBW performance requirements are imposed with respect to achieving a small Critical Dimension (CD) and, in particular, to achieving 3sigma or 6sigma variations at a nanometer level of the Local CD Uniformity (LCDU) within small fields (e.g. the area of the MBW beam array field) as well as nanometer level 3sigma or 6sigma variations of the Global CD Uniformity (GCDU) over the whole MBW writing field on a substrate (e.g. a 6" mask blank or a 300mm Silicon wafer).

Furthermore, it is desired to fine-adjust the line edge position by means of a specifically adapted exposure dose profile. Furthermore, such a fine-adjustment should not only be adaptable within the MBW beam array field (local) but also over the whole MBMW writing field on a substrate (global).

Using the MBW architecture of the applicant, low CD values can be achieved and small LCDU and GCDU values. However, in order to fulfill the very demanding MBW specifications of very low LCDU and GCDU values, there is the need for additional fine corrections. Here, the terms "local" and "global" refer again to small fields (e.g. the area of the MBW beam array field) and the whole MBW writing field on a substrate, respectively.

The patent document US 8,378,320 B2 of the applicant describes a multi-beam writing method, where the target (substrate) is exposed in a sequence of exposure stripes. The exposure stripes are realized by mechanically scanning the substrate in one direction (e.g.: +X) and in the opposite direction (-X) by means of a target stage on which the target is placed. In order to move from one stripe exposure to the next, the substrate is moved in the perpendicular direction by a distance which corresponds to the stripe width or, in the case of overlapping stripes, by a smaller amount depending on the stripe overlap chosen.

However, it was observed that the multi-beam writing method by exposure stripes may, in certain situations, suffer from an effect called "substripes". More in detail, the beamlets may be affected by imperfections arising from, e.g., spatial variations in the current density within the beam illuminating the AAP; also imperfections within the AAP may contribute, such as deviations of the shape or area of the apertures in the pattern definition device. Thus, the current dose of the beamlets generated by the apertures in the AAP may vary between different beamlets, which can cause striped variation patterns ("substripes") over the exposure area.

In view of the above, it is an objective of the present invention to overcome these shortcomings of prior art.

Summary of the invention

According to the invention, the inventors found that it is possible to avoid the "substripe" effect by applying a correction to the nominal dose amounts at the pixels, where the presence of overlapping stripes is taken into account by suitable averaging of the correction factors. More specifically, starting from a method as cited in the beginning, wherein the exposure stripes are mutually overlapping wherein overlapping exposure stripes are located at different transversal offsets as taken along a direction transversal to the scanning direction, such that each area of said region is exposed by at least two different areas of the pattern image at different transversal offsets, the method further comprises a step of calculating corrected dose amounts: namely, calculating, for each pixel, a corrected dose amount by dividing the value of the nominal dose amount by a correction factor, wherein the same correction factor is used with those pixels that are located at positions which differ only by said transversal offsets of overlapping stripes - or more exactly, with pixels written by those beamlets that are located at positions which differ only by said transversal offsets of overlapping stripes (as seen at the location of the target). In other words, the same correction factor is used for those pixels/beamlets that have equivalent positions modulo said transversal offsets of overlapping stripes. In general, the correction factor will vary between the groups of pixels defined by this equivalence, or in other words will be different for (groups of) pixels/beamlets whose positions are not equivalent modulo said transversal offsets of overlapping stripes (i.e., the positional offset between pixels of different groups does not correspond to a transversal offset of overlapping stripes).

In a suitable implementation of this method of the invention, the correction factors are calculated to correct variations of the current density within the irradiating beam. Thus, during the step of calculating a corrected dose amount for each pixel, the following steps may suitable be performed:

- an available current density at the respective pixel is determined, wherein said available current density is determined as the actual current density of the irradiating beam radiated through the aperture corresponding to the respective pixel;
- the correction factor of the respective pixel is calculated as the ratio of said available current density to the minimum current density across the overall beam array field; and
- an averaging of correction factors is made within respective sets of pixels, namely by averaging the correction factors among those pixels that are located at positions which differ only by said transversal offsets of overlapping stripes.

Optionally, a multiplicative renormalization of the correction factors, in particular the averaged correction factors, may be added, for instance such that the largest or, preferably, the smallest (averaged) correction factor is set to 1.

A further development of this method extends the range of averaging to an entire row of pixels. Thus, in this case the step of calculating a corrected dose amount for each pixel comprises calculating, for each pixel in a row of pixels parallel to the scanning direction within a respective exposure stripe, corrected dose amounts by dividing the values of the dose amounts by a row correction factor, wherein said row correction factor is uniformly applied to all pixels of a row of pixels. In addition, said row correction factor may be calculated for a respective row of pixels based on the values of current dose actually radiated through a series of apertures, where such a series of apertures contains all apertures within the pattern definition device which impart dose amounts to the respective row of pixels, wherein the row correction factor of a row of pixels is calculated as the ratio of actual current dose of an aperture, as averaged over the corresponding series of apertures, to a nominal current dose value assumed to be constant over the plurality of apertures of the pattern definition device.

Furthermore, said region where a beam exposure is to be performed may be, according to another suitable extension of the invention, composed of a plurality of pattern pixels arranged in a regular arrangement, said region having a total width as measured across said scanning direction; further, the exposure stripes within said region will run substantially parallel to each other along said scanning direction and have uniform widths as measured across said scanning direction. In addition, it may be suitable to average row correction factors of rows of pixels over those rows of pixels which are offset to each other by said transversal offset.

A yet further development, which further improves avoiding the "substripe" effect and similar rasterizing effects, relates to a method as described above including computing an exposure pattern as defined in present deppendent claim 9.

The inventors found that, compared to other dithering methods, ordered dithering has several advantages in context of a charged particle multibeam writer. Firstly, it is computationally inexpensive which is highly important for a fast (i.e. real-time) data processing in the datapath. Secondly, it is a deterministic procedure, which means that its results are uniquely reproducible. Thirdly, the ordered dithering matrix can be chosen (i.e. optimized) in a way such that line edge placement and line edge roughness in specific directions becomes optimal. This is particularly useful since the layout of semi-conductor devices mainly have two preferred (orthogonal) axes, i.e. usually horizontal and vertical lines are more important and dominant as compared to lines in arbitrary direction.

Brief description of the drawings

In the following, in order to further demonstrate the present invention, illustrative and non-restrictive embodiments are discussed, as shown in the drawings, which show:

| | |
|---|---|
| Fig. 1 | a MBW system of state of the art in a longitudinal sectional view; |
| Fig. 2 | a pattern definition system state of the art in a longitudinal section; |
| Fig. 3 | illustrates the writing strategy on the target using stripes arranged along a common scanning direction; |
| Fig. 4 | shows an example of a pixel map of an exemplary pattern to be exposed; |
| Fig. 5 | shows an exemplary arrangement of apertures as imaged onto the target; |
| Fig. 6A | illustrates an arrangement of apertures with M=2, N=2; |
| Fig. 6B | shows an example of oversampling of the pixels in a "double grid" arrangement; |
| Fig. 7 | illustrates the exposure of one stripe; |
| Fig. 8A and 8B | illustrate the overlapping stripe ("multi-pass") strategy for the example of two passes, i.e. the so-called "double-pass" mode; |
| Fig. 9 | illustrate the intensity profile which is generated when one single exposure spot is exposed with a maximum dose; |
| Fig. 10A | illustrates an intensity profile of the MBW of the type shown in Fig. 1, and a dose level profile for a 30 nm line; |
| Fig. 10B | shows an intensity profile for the 30 nm line dose level profile of Fig. 10A; |
| Figs. 10c and 10D | illustrate MBW intensity profiles and related data as obtained for a simulation of a line, with a line width of 31.4 nm (Fig. 10C) and 40.0 nm (Fig. 10D), respectively. |
| Fig. 11A | illustrates the intensity profile generated from the exposure of a line of a determined width; |
| Figs. 11B,C | illustrate the fine adjustment of the position of one edge (Fig. 11B) or both edges (Fig. 14c) of the line of Fig. 11A via suitable modifications of the dose levels corresponding the exposure spots; |
| Fig. 12 | an example of a measured current density map, expressed as relative deviations in per cent from a uniform nominal value, exhibiting an inhomogeneity of the particle source |
| Fig. 13 | shows the data path of the MBW; |
| Figs. 14 and 15 | illustrate dithering for the example of double-grid oversampling, with Fig. 14 illustrating the four pixel elements contributing to one "overlapping area" in the double-grid, and Fig. 15 illustrating the five possible configurations of dose in the case of two pixel dose levels; |
| Fig. 16 | illustrates dithering for an example with o=2; |
| Figs. 17A,B | show the index matrix and the threshold matrix, respectively, used for the dithering process of Fig. 16; |

| Fig. 18 | illustrates dithering for an example with o=4; |
| Figs. 19A,B | show the index matrix and the threshold matrix, respectively, used for the dithering process of Fig. 18; |
| Fig. 20 | shows another example of the dithering process; |
| Fig. 21 | shows yet another example of the dithering process; |
| Fig. 22 | shows a further example of the dithering process including a correction of beam current inhomogeneity; |
| Fig. 23 | shows a variant of the example of Fig. 22 including a correction of beam current inhomogeneity which is uniform along the scanning direction; |
| Figs. 24 and 25 | show further examples illustrating further scenarios of the dithering process, in depictions analogous to Figs. 22 and 23, respectively; |
| Fig. 26 | is a plot of the rounding error as a function of the nominal target dose; |
| Fig. 27-1 | shows an exemplary typical current profile across an image field; |
| Fig. 27-2 | shows the current profile of Fig. 27-2 averaged along the X-direction; |
| Fig. 28-1 | shows correction dose factors for the current profile of Fig. 27-1; |
| Fig. 28-2 | shows correction dose factors for a uniform correction, i.e. uniform along the X-direction; |
| Fig. 29-1 | shows the corrected dose profile as obtained from Figs. 27-1 and 28-1; |
| Fig. 29-2 | shows the corrected dose profile as obtained from Figs. 27-2 and 28-2; |
| Figs. 30-1 to 32-2 | show current profiles, correction dose factors and corrected dose profiles in a manner analogous to Figs. 27-1 to 29-2, respectively, for the case of overlapping exposure stripes in a two-pass process; |
| Figs. 33-1 to 35-2 | show current profiles, correction dose factors and corrected dose profiles in a manner analogous to Figs. 27-1 to 29-2, respectively, for the case of overlapping exposure stripes in a four-pass process. |

Detailed description of embodiments of the invention

The embodiment discussed below introduces the invention, a novel dose-level quantization method for pixel-data, as part of the on-line data path of a lithographic charged particle multi-beam exposure tool of the applicant (as disclosed in U.S. Pat. No. 6,768,125 and U.S. Pat. No. 7,781,748, but with suitable modifications so as to accommodate the invention). It will be evident to the person skilled in the art to freely combine several or all of the embodiments discussed here as deemed suitable for a specific application of the invention. Throughout this disclosure, terms like "advantageous", "exemplary" or "preferred" indicate elements or dimensions which are particularly suitable (but not essential) to the invention or an embodiment thereof, and may be modified wherever deemed suitable by the skilled person, except where expressly required. It should be appreciated that the invention is not restricted to the exemplary embodiments discussed in the following, which are given for illustrative purpose and merely represent suitable implementations of the invention, which is defined by the independent claim.

**Lithographic Apparatus**

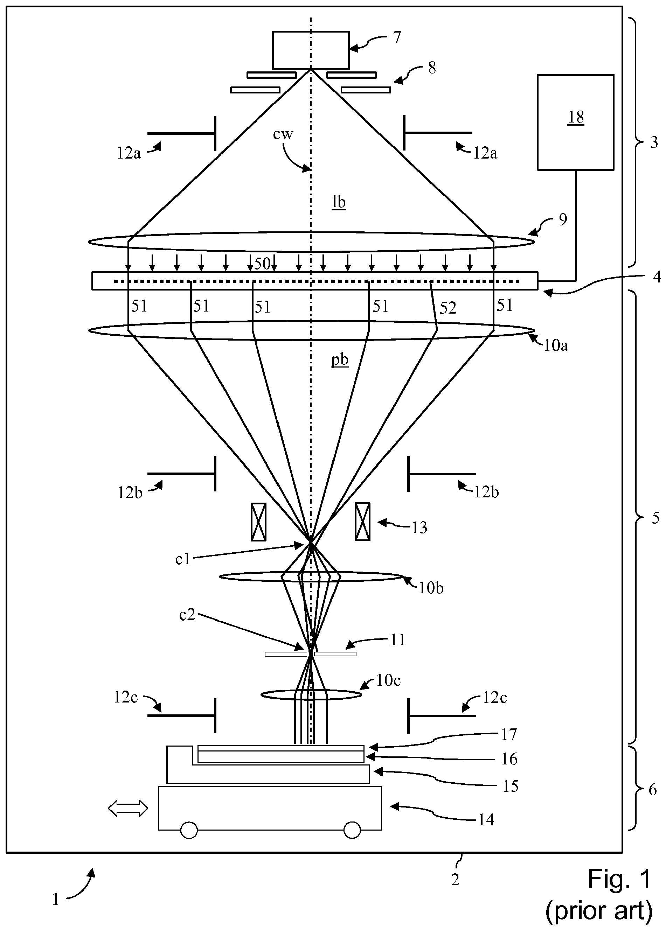

An overview of a lithographic apparatus suitable to employ the preferred embodiment of the invention is shown in Fig. 1. In the following, only those details are given as needed to disclose the invention; for the sake of clarity, the components are not shown to size in Fig. 1. The main components of the lithography apparatus 1 are - corresponding to the direction of the lithography beam lb, pb which in this example runs vertically downward in Fig. 1 - an illumination system 3, a pattern definition (PD) system 4, a projecting system 5, and a target station 6 with the substrate 16. The whole apparatus 1 is contained in a vacuum housing 2 held at high vacuum to ensure an unimpeded propagation of the beam lb, pb of charged particles along the optical axis cw of the apparatus. The charged-particle optical systems 3, 5 are realized using electrostatic and/or magnetic lenses.

The illumination system 3 comprises, for instance, an electron gun 7, an extraction system 8 as well as a condenser lens system 9. It should, however, be noted that in place of electrons, in general, other electrically charged particles can be used as well. Apart from electrons these can be, for instance, hydrogen ions or heavier ions, charged atom clusters, or charged molecules. The extraction system 8 accelerates the particles to a defined energy of typically several keV, e.g. 5 keV. By means of a condenser lens system 9, the particles emitted from the source 7 are formed into a broad, substantially telecentric particle beam 50 serving as lithography beam lb. The lithography beam lb then irradiates a PD system 4 which comprises a number of plates with a plurality of openings (also referred to as apertures). The PD system 4 is held at a specific position in the path of the lithography beam lb, which thus irradiates the plurality of apertures and/or openings and is split into a number of beamlets.

Some of the apertures/openings are "switched on" or "open" so as to be transparent to the incident beam in the sense that they allow the portion of the beam that is transmitted through it, i.e. the beamlets 51, to reach the target; the other apertures/openings are "switched off" or "closed", i.e. the corresponding beamlets 52 cannot reach the target, and thus effectively these apertures/openings are non-transparent (opaque) to the beam. Thus, the lithography beam lb is structured into a patterned beam pb, emerging from the PD system 4. The pattern of switched on apertures - the only portions of the PD system 4 which are transparent to the lithography beam lb - is chosen according to the pattern to be exposed on the substrate 16 covered with charged-particle sensitive resist 17. It has to be noted that the "switching on/off" of the apertures/openings is usually realized by a suitable type of deflection means provided in one of the plates of the PD system 4: "Switched off" beamlets 52 are deflected off their path (by sufficient albeit very small angles) so they cannot reach the target but are merely absorbed somewhere in the lithography apparatus, e.g. at an absorbing plate 11.

The pattern as represented by the patterned beam pb is then projected by means of an electro-magneto-optical projection system 5 onto the substrate 16 where the beam forms an image of the "switched-on" apertures and/or openings. The projection system 5 implements a demagnification of, for instance, 200:1 with two crossovers c1 and c2. The substrate 16 is, for instance, a 6" mask blank or a silicon wafer covered with a particle sensitive resist layer 17. The substrate is held by a chuck 15 and positioned by a substrate stage 14 of the target station 6.

The information regarding the pattern to be exposed is supplied to the PD system 4 by the data path realized by means of an electronic pattern information processing system 18. The data path is explained further below in section "Datapath".

In Fig. 1, the projection system 5 is composed of a number of consecutive electro-magneto-optical projector stages 10a, 10b, 10c, which preferably include electrostatic and/or magnetic lenses, and possibly other deflection means. These lenses and means are shown in symbolic form only, since their application is well known in the prior art. The projection system 5 employs a demagnifying imaging through crossovers c1, c2. The demagnification factor for both stages is chosen such that an overall demagnification of several hundred results, e.g. 200:1 reduction. A demagnification of this order is in particular suitable with a lithography setup, in order to alleviate problems of miniaturization in the PD device. In the whole projection system 5, provisions are made to extensively compensate the lenses and or deflection means with respect to chromatic and geometric aberrations. As a means to shift the image laterally as a whole, i.e. along a direction perpendicular to the optical axis cw, deflection means 12a, 12b and 12c are provided in the condenser 3 and projection system 5. The deflection means may be realized as, for instance, a multipole electrode system which is either positioned near the source extraction system 8 or one of the crossovers, as shown in Fig. 1 with the deflection means 12b, or after the final lens 10c of the respective projector, as in the case with the stage deflection means 12c in Fig. 1. In this apparatus, a multipole electrode arrangement is used as deflection means both for shifting the image in relation to the stage motion and for correction of the imaging system in conjunction with the charge-particle optics alignment system. These deflection means 10a, 10b, 10c are not to be confused with the deflection array means of the PD system 4 in conjunction with the stopping plate 11, as the latter are used to switch selected beamlets of the patterned beam pb "on" or "off", whereas the former only deal with the particle beam as a whole. There is also the possibility to rotate the ensemble of programmable beams using a solenoid 13 providing an axial magnetic field.

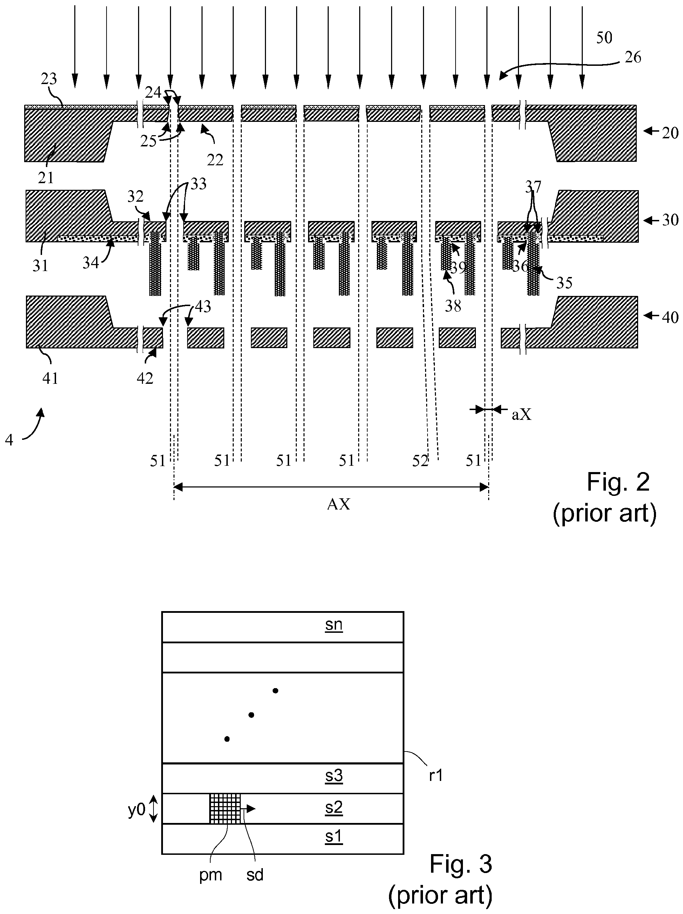

The sectional detail of Fig. 2 illustrates one suitable PD system 4, which comprises three plates stacked in a consecutive configuration: An "Aperture Array Plate" (AAP) 20, a "Deflection Array Plate" (DAP) 30 and a "Field-boundary Array Plate" (FAP) 40. It is worthwhile to note that the term 'plate' refers to an overall shape of the respective device, but does not necessarily indicate that a plate is realized as a single plate component even though the latter is usually the preferred way of implementation; still, in certain embodiments, a 'plate', such as the aperture array plate, may be composed of a number of sub-plates. The plates are preferably arranged parallel to each other, at mutual distances along the Z direction (vertical axis in Fig. 2).

The flat upper surface of AAP 20 forms a defined potential interface to the charged-particle condenser optics/illumination system 3. The AAP may, e.g. be made from a square or rectangular piece of a silicon wafer (approx. 1mm thickness) 21 with a thinned center part 22. The plate may be covered by an electrically conductive protective layer 23 which will be particularly advantageous when using hydrogen or helium ions (like in US 6,858,118). When using electrons or heavy ions (e.g. argon or xenon), the layer 23 may also be of silicon provided by the surface section of 21 and 22, respectively, so that there is no interface between layer 23 and the bulk parts 21, 22.

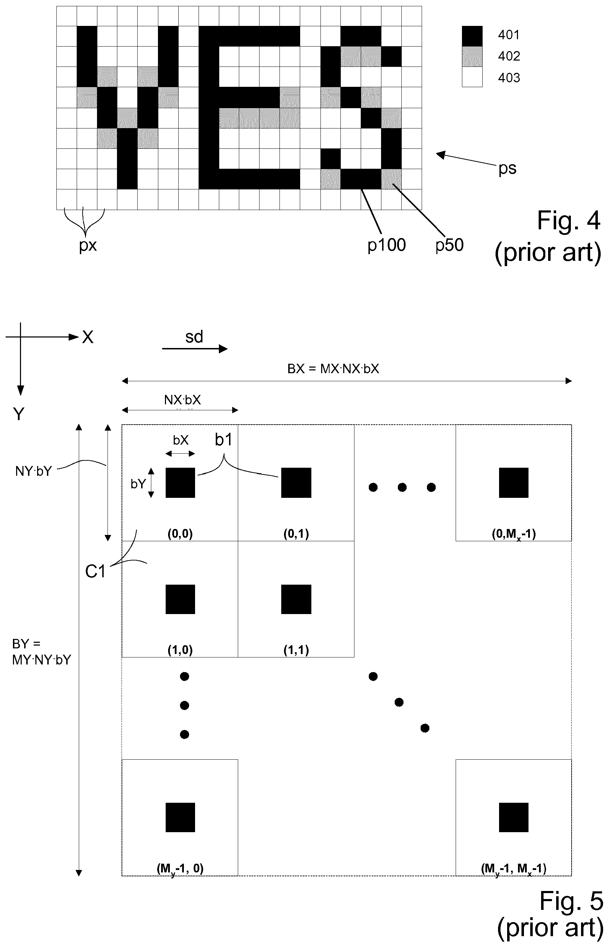

The AAP 20 is provided with a plurality of apertures 24 formed by openings traversing the thinned part 22. The apertures 24 are arranged in a predetermined arrangement within an aperture area provided in the thinned part 22, thus forming an aperture array 26. The arrangement of the apertures in the aperture array 26 may be, for instance, a staggered arrangement or a regular rectangular or square array (cf. Fig. 4). In the system shown, the apertures 24 are realized having a straight profile fabricated into the layer 23 and a "retrograde" profile in the bulk layer of the AAP 20 such that the downward outlets 25 of the openings are wider than in the main part of the apertures 24. Both the straight and retrograde profiles can be fabricated with state-of-the-art structuring techniques such as reactive ion etching. The retrograde profile strongly reduces mirror charging effects of the beam passing through the opening.

The DAP 30 is a plate provided with a plurality of openings 33, whose positions correspond to those of the apertures 24 in the AAP 20, and which are provided with electrodes 35, 38 configured for deflecting the individual beamlets passing through the openings 33 selectively from their respective paths. The DAP 30 can, for instance, be fabricated by post-processing a CMOS wafer with an ASIC circuitry. The DAP 30 is, e.g., made from a piece of a CMOS wafer having a square or rectangular shape and comprises a thicker part 31 forming a frame holding a center part 32 which has been thinned (but may be suitably thicker as compared to the thickness of the tinned part 22). The aperture openings 33 in the center part 32 are wider compared to 24 (by approx. $2\mu$m at each side for instance). CMOS electronics 34 is provided to control the electrodes 35, 38, which are provided by means of MEMS techniques. Adjacent to each opening 33, a "ground" electrode 35 and a deflection electrode 38 are provided. The ground electrodes 35 are electrically interconnected, connected to a common ground potential, and comprise a retrograde part 36 to prevent charging and an isolation section 37 in order to prevent unwanted shortcuts to the CMOS circuitry. The ground electrodes 35 may also be connected to those parts of the CMOS circuitry 34 which are at the same potential as the silicon bulk portions 31 and 32.

The deflection electrodes 38 are configured to be selectively applied an electrostatic potential; when such electrostatic potential is applied to an electrode 38, this will generate an electric field causing a deflection upon the corresponding beamlet, deflecting it off its nominal path. The electrodes 38 as well may have a retrograde section 39 in order to avoid charging. Each of the electrodes 38 is connected at its lower part to a respective contact site within the CMOS circuitry 34.

The height of the ground electrodes 35 is higher than the height of the deflection electrodes 38 in order to suppress cross-talk effects between the beamlets.

The arrangement of a PD system 4 with a DAP 30 shown in Fig. 2 is only one of several possibilities. In a variant (not shown) the ground and deflection electrodes 35, 38 of the DAP may be oriented upstream (facing upward), rather than downstream. Further DAP configurations, e.g. with embedded ground and deflection electrodes, can be devised by the skilled person (see other patents in the name of the applicant, such as US 8,198,601 B2).

The third plate 40 serving as FAP has a flat surface facing to the first lens part of the downstream demagnifying charged-particle projection optics 5 and thus provides a defined potential interface to the first lens 10a of the projection optics. The thicker part 41 of FAP 40 is a square or rectangular frame made from a part of a silicon wafer, with a thinned center section 42. The FAP 40 is provided with a plurality of openings 43 which correspond to the openings 24, 33 of the AAP 20 and DAP 30 but are wider as compared to the latter .

The PD system 4, and in particular the first plate of it, the AAP 20, is illuminated by a broad charged particle beam 50 (herein, "broad" beam means that the beam is sufficiently wide to cover the entire area of the aperture array formed in the AAP), which is thus divided into many thousands of micrometer-sized beamlets 51 when transmitted through the apertures 24. The beamlets 51 will traverse the DAP and FAP unhindered.

As already mentioned, whenever a deflection electrode 38 is powered through the CMOS electronics, an electric field will be generated between the deflection electrode and the corresponding ground electrode, leading to a small but sufficient deflection of the respective beamlet 52 passing therethrough (Fig. 2). The deflected beamlet can traverse the DAP and FAP unhindered as the openings 33 and 43, respectively, are made sufficiently wide. However, the deflected beamlet 52 is filtered out at the stopping plate 11 of the sub-column (Fig. 1). Thus, only those beamlets which are unaffected by the DAP will reach the substrate.

The reduction factor of the demagnifying charged-particle optics 5 is chosen suitably in view of the dimensions of the beamlets and their mutual distance in the PD device 4 and the desired dimensions of the structures at the target. This will allow for micrometer-sized beamlets at the PD system whereas nanometer-sized beamlets are projected onto the substrate.

The ensemble of (unaffected) beamlets 51 as formed by AAP is projected to the substrate with a predefined reduction factor R of the projection charged-particle optics. Thus, at the substrate a "beam array field" (BAF) is projected having widths $BX = AX/R$ and $BY = AY/R$, respectively, where AX and AY denote the sizes of the aperture array field along the X and Y directions, respectively. The nominal width of a beamlet at the substrate (i.e. aperture image) is given by $bX = aX/R$ and $bY = aY/R$, respectively, where aX and aY denote the sizes of the beamlet 51 as measured along the X and Y directions, respectively, at the level of the DAP 30. Thus, the size of a single aperture image formed on the target is $bX \times bY$.

It is worthwhile to note that the individual beamlets 51, 52 depicted in Fig. 2 represent a much larger number of beamlets, typically many thousands, arranged in a two-dimensional X-Y array. The applicant has, for instance, realized multi-beam charged-particle optics with a reduction factor of R = 200 for ion as well as electron multi-beam columns with many thousands (e.g., 262,144) programmable beamlets. The applicant has realized such columns with a BAF of approx. $82\mu$m $\times$ $82\mu$m at the substrate. These examples are stated for illustrative purpose, but are not to be construed as limiting examples.

**Pattern exposure**

Referring to Fig. 3, a pattern image pm as defined by the PD system 4 is produced on the target 16. The target surface covered with the charged-particle sensitive resist layer 17 will comprise one or more areas r1 to be exposed. Generally, the pattern image pm exposed on the target has a finite size y0 which is usually well smaller than the width of the area r1 which is to be patterned. Therefore, a scanning stripe exposure strategy is utilized, where the target is moved under the incident beam, so as to change the position of the beam on the target perpetually: the beam is effectively scanned over the target surface. It is emphasized that for the purpose of the invention only the relative motion of the pattern image pm on the target is relevant. By virtue of the relative movement the pattern image pm is moved over the area r1 so as to form a sequence of stripes s1, s2, s3, ... sn (exposure stripes) of width y0. The complete set of stripes covers the total area of the substrate surface. The scanning direction sd may be uniform (same orientation) or may alternate from one stripe to the next.

Fig. 4 shows a simple example of an imaged pattern ps with a size of $10 \times 18 = 180$ pixels, where some pixels p100 of the exposure area are exposed to a gray level 401 of 100% and other pixels p50 are exposed 402 to only 50% of the full gray level. The remaining pixels are exposed to a 0% dose 403 (not exposed at all). Of course, in a realistic application of the invention, the number of pixels of the standard image would be much higher. However, in Fig. 5 the number of pixels is only 180 for the better clarity. Also, in general, much more gray levels will be used within the scale from 0% to 100%.

Thus, the pattern image pm (Fig. 3) is composed of a plurality of pattern pixels px, which are exposed with dose values according to the desired pattern to be exposed. It should be appreciated, however, that only a subset of the pixels px can be exposed simultaneously since only a finite number of apertures is present in the aperture field of the PD system. The pattern of switched-on apertures is chosen according to the pattern to be exposed on the substrate. Thus, in an actual pattern not all pixels are exposed at the full dose, but some pixels will be "switched off" in accordance with the actual pattern; for any pixel (or, equivalently, for every beamlet covering the pixel) the exposure dose can vary from one pixel exposure cycle to the next whether the pixel is "switched on" or "switched off", depending on the pattern to be exposed or structured on the target.

While the substrate 16 is moved continuously, the same image element corresponding to a pattern pixel px on the target may be covered many times by the images of a sequence of apertures. Simultaneously, the pattern in the PD system is shifted, step by step, through the apertures of the PD system. Thus, considering one pixel at some location on the target, if all apertures are switched on when they cover that pixel, this will result in the maximum exposure dose level: a "white" shade corresponding to 100%. In addition to a "white" shade, it is possible to expose a pixel at the target according to a lower dose level (also dubbed 'gray shade') which would interpolate between the minimal ('black') and maximal ('white') exposure dose levels. A gray shade may, for instance, be realized by switching on only a subset of apertures that may be involved in writing one pixel; for example, 4 out of 16 apertures would give a gray level of 25%. Another approach is reducing the duration of unblanked exposure for the apertures involved. Thus, the exposure duration of one aperture image is controlled by a discrete number of gray levels; each of which represents a particular dose to be applied on the substrate/target, e.g. $0, 1/(n_Y-1) ..., i/(n_Y-1), ..., 1$ with $n_Y$ being the number of available "pixel gray levels" and i an integer ("gray index", $0 \leq i \leq n_Y$). Generally, however, the dose increments need not be equidistant and form a non-decreasing sequence between 0 and 1. The exposed aperture image is the manifestation of one of a given numbers of gray shades that correspond to zero and the maximum exposure duration and dose level.

Fig. 5 shows the arrangement of apertures in the aperture field of the PD device, according to a basic layout and also illustrates several quantities and abbreviations used in the following. Shown is the arrangement of the aperture images b1 as projected onto the target, shown in dark shades. The main axes X and Y correspond to the direction of advance of the target motion (scanning direction sd) and the perpendicular direction, respectively. Each aperture image has widths bX and bY along the directions X and Y respectively. The apertures are arranged along lines and rows having MX and MY apertures, respectively, with the offset between neighboring apertures in a line and row being NX·bX and NY·bY respectively. As a consequence, to each aperture image belongs a conceptual cell C1 having an area of NX·bX·NY·bY, and the aperture arrangement contains MX·MY cells arranged in a rectangular way. In the following, these cells C1 are referred to as "exposure cells". The complete aperture arrangement, as projected onto the target, has dimensions of BX = MX·NX·bX by BY = MY·NY·bY. In the discussion hereinafter, we will assume a square grid as a special case of a rectangular grid, and set b = bX = bY, M = MX = MY, and N = NX = NY with M being an integer, for all further explanations without any restriction of the generality. Thus, an "exposure cell" has a size of $N \cdot b \times N \cdot b$ on the target substrate.

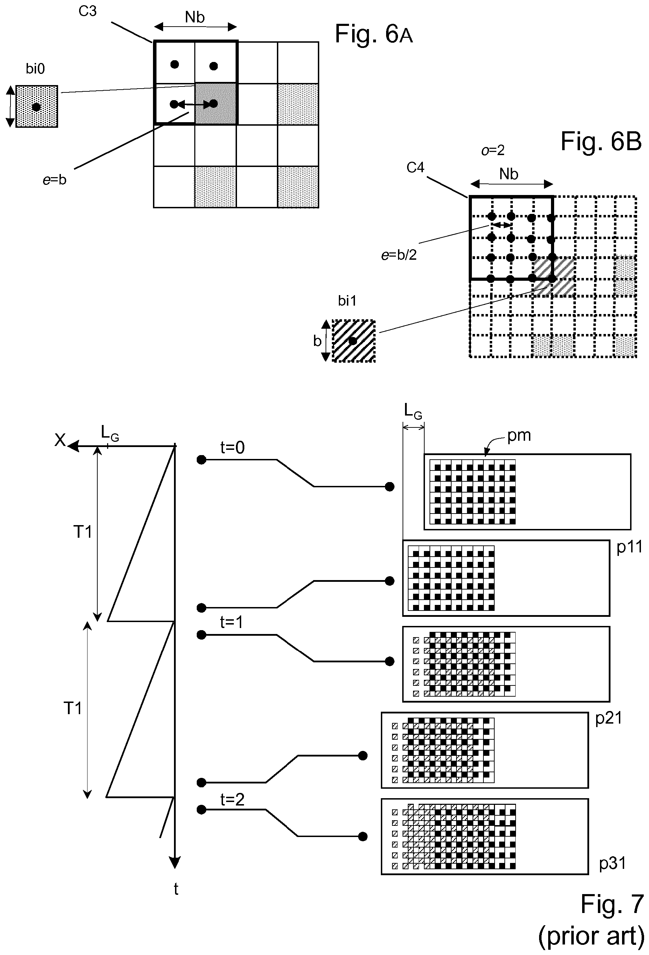

The pitch between two neighboring exposure positions is denoted as e in the following. In general, the distance e can be different from the nominal width b of an aperture image. In the simplest case, b = e, which is illustrated in Fig. 6A for the example of an arrangement of $2 \times 2$ exposure cells C3, and one aperture image bi0 covers (the nominal position of) one pixel. In another interesting case, illustrated in Fig. 6B (and in line with the teachings of US 8,222,621 and US 7,276,714), e may be a fraction b/o of the width b of the aperture image, with o>1 being preferably (but not necessarily) an integer which we also refer to as the oversampling factor. In this case the aperture images, in the course of the various exposures, will spatially overlap, allowing a higher resolution of the placement of the pattern to be developed. It follows that each image of an aperture will, at one time, cover multiple pixels, namely $o^2$ pixels. The entire area of the aperture field as imaged to the target will comprise $(NMo)^2$ pixels. From the point of view of placement of aperture image, this oversampling corresponds to a so-called placement grid which is different (since it is finer in spacing) than what would be necessary to simply cover the target area.

Fig. 6B illustrates one example of an oversampling of o=2 combined with placement grids, namely, the image of an aperture array with an exposure cell C4 having parameters o=2, N=2 ("double-grid"). Thus, on each nominal location (small square fields in Fig. 6B) four aperture images bi1 (dashed lines) are printed, which are offset on a regular grid by pitch e in both X and Y directions. While the size of the aperture image still is of the same value b, the pitch e of the placement grid is now b/o = b/2. The offset to the previous nominal location (offset of the placement grid) is also of size b/2. At the same time, the dose and/or the gray shade of each pixel may be adapted (reduced), by choosing a suitable gray value for the aperture image that cover the respective pixel. As a result, an area of size b×b is printed but with an enhanced placement accuracy due to the finer placement grid. Direct comparison of Fig. 6B with Fig. 6A shows that locations of aperture images are just arranged on a placement grid twice (generally, o times) as fine as before, while the aperture images themselves overlap. The exposure cell C4 now contains $(No)^2$ locations (i.e., "pixels") to be addressed during the write process and thus, by a factor of $o^2$, more pixels than before. Correspondingly, the area bi1 with the size of an aperture image b×b is associated with $o^2$ = 4 pixels in the case of oversampling with o=2 in Fig. 6B. Of course, o may take any other integer value as well, in particular 4 ("quad-grid", not shown) or 8, or also a non-integer value greater one, such as √2 = 1.414.

Fig. 7 shows an exposure scheme of the pixels, which is suitable for the invention. Shown is a sequence of frames, with increasing time from top (earlier) to bottom (later). The parameter values in this figure are o=1, N=2; also, a rectangular beam array is assumed with MX = 8 and MY = 6. The target moves continuously to the left, whereas the beam deflection is controlled with a seesaw function as shown on the left side of the figure. During each time interval of length T1, the beam image stays fixed on a position on the target (corresponding to a position of a "placement grid"). Thus, the beam image is shown to go through a placement grid sequence p11, p21, p31. One cycle of placement grids is exposed within a time interval L/v = NMb/v, by virtue of the target motion v. The time T1 for exposure at each placement grid corresponds to a length $L_G = vT1 = L/(No)^2 = bM/No^2$, which we call "exposure length".

The beamlets are moved over the distance of $L_G$ during the exposure of one set of image elements together with the target. In other words, all beamlets maintain a fixed position with regard to the surface of the substrate during the time interval T1. After moving the beamlets with the target along distance $L_G$, the beamlets are relocated instantaneously (within a very short time) to start the exposure of the image elements of the next placement grid. After a full cycle through the positions p11... p31 of a placement grid cycle, the sequence starts anew, with an additional longitudinal offset L = bNM parallel to the X direction (scanning direction). At the beginning and at the end of the stripe the exposure method may not produce a contiguous covering, so there may be a margin of length L that is not completely filled.

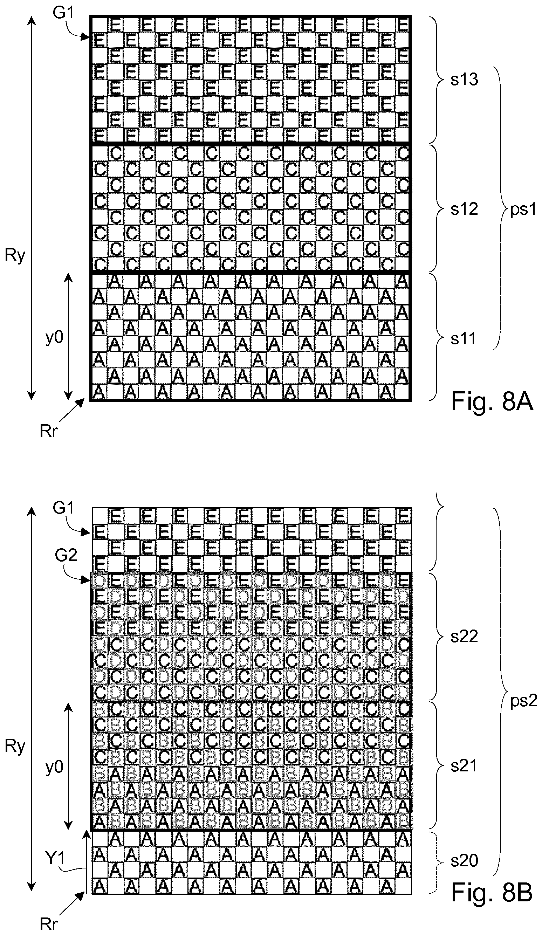

The applicant described an overlapping stripe ("multi-pass") strategy for error reduction in US 9,053,906 B2. An example of such a strategy ("double-pass") is illustrated in Figs. 8A and 8B, which show an exemplary sub-area of the target to be exposed in two passes ps1, ps2. In the first pass ps1 the stripes s11, s12, s13 are exposed in consecutive order, thus exposing the pixels belonging to a partial grid G1 (the number of pixels within each of the stripes is reduced in the depiction of Figs. 8A and 8B for the sake of clarity and will be higher in an a typical embodiment of the invention). In Fig. 8A, letters A, C, E denote the pixels which are exposable through stripes s11, s12, and s13, respectively. The stripes s11-s13 of one pass are preferably located side-by-side, so as to produce a continuous grid over the area on the target. In this way, the stripes, each having individual width y0, cover the total width Ry of the area Rr to be exposed along the Y direction (i.e., across the scanning direction sd). The stripes s11-s13 may extend to either side of the area shown, and the first pass ps1 may continue with further stripes (not shown) after the stripe s13 has been imaged. After completion of all stripes of the first pass ps1, the stripes of another pass ps2 are performed, as illustrated in Fig. 8B. The stripes s21, s22 expose pixels formed within the second partial grid G2. Fig. 8B shows two stripes s21, s22, which expose the pixels denoted by letters B and D, respectively. Thus, each pass ps1, ps2 is associated with one of the partial grids G1, G2 of pattern pixels which are exposable during the respective pass. Taken together, the pixels of the grids G1, G2 combine to the complete plurality of pattern pixels in the region which is to be exposed. In other words, the second pass ps2 exposes those pixels which are left out in the first pass ps1, and vice versa. With regard to the Y axis the exposure stripes of different passes are mutually overlapping, preferably in a regular manner wherein the overlapping stripes, for instance of stripes s11 and s21, differ by a transversal offset Y1 along the Y direction (which is the direction across the orientation of the stripes, identical to the scanning direction). For exposing the first half of the stripe s11, and to also cover this part of the total width Ry, an additional 'edge stripe' s20 (not indicated in the pixel pattern) may be performed, in which only the upper half of the pixels are exposed, while the lower half of the pixels are kept switched-off along the entire length of the stripe s20. This approach generalizes in a straightforward manner to more than two passes; for instance, in a "quad-pass" writing strategy, four partial grids written in four passes are combined to form the complete plurality of pattern pixels. Further details concerning the exposure of the pixels through exposure stripes and partial grids are described in US 2016/0276131 A1 by the applicant.

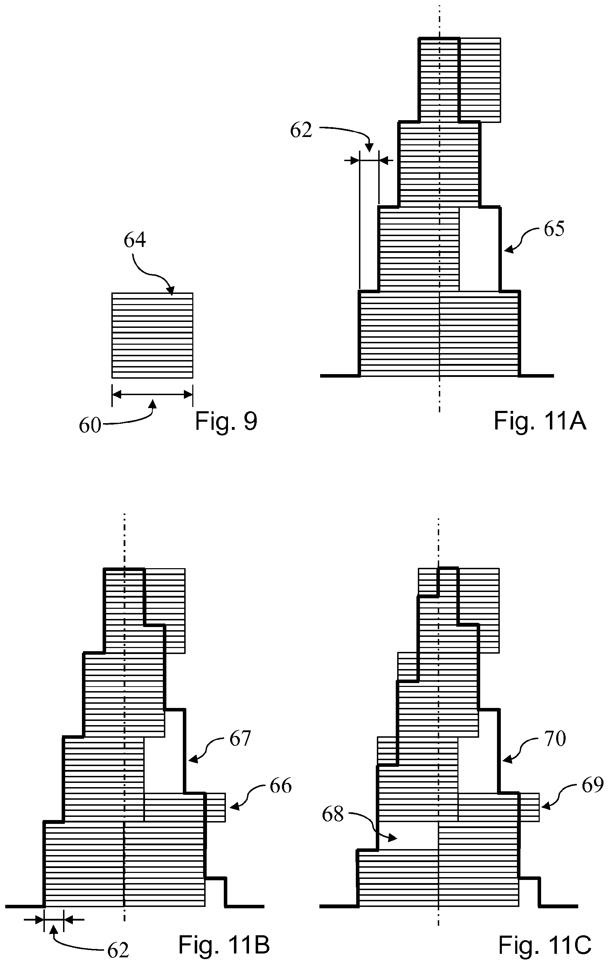

We now describe how dose variations can be utilized in the MBMW of the applicant to achieve edge placement with sub-pixel precision. Fig. 9 illustrates the exposure of one exposure spot with a maximum dose level. In the exemplary case of a 4-bit coding, there are 16 dose levels (0,1, 2, ....15), i.e. the maximum dose level is the sum of 15 dose level increments 64.

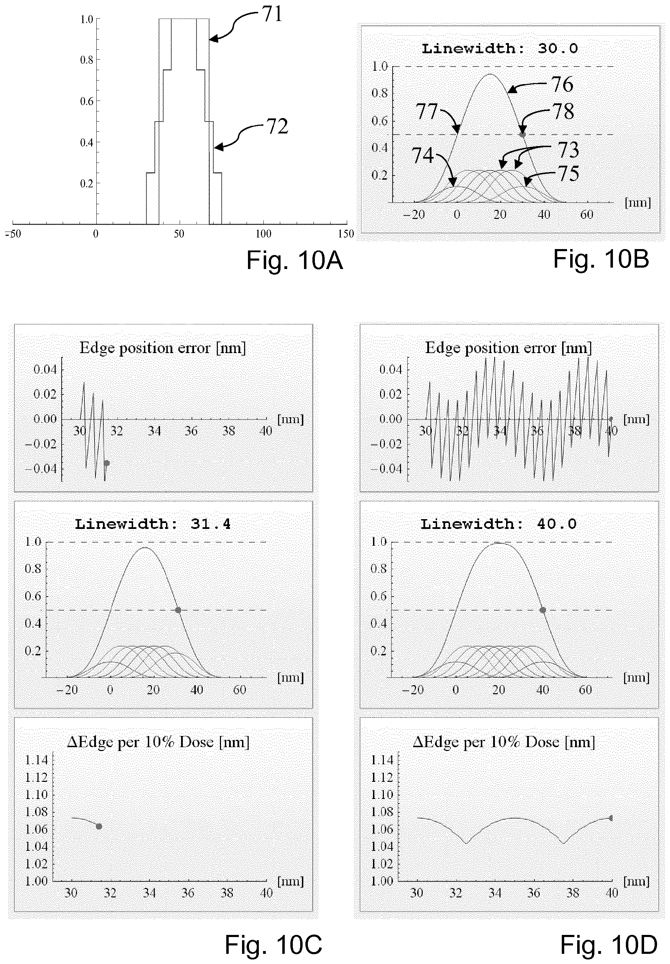

Fig. 10A shows the ideal intensity profile 71 for a line of a width 30 nm, in the idealized case of zero blur. When using "quad-grid" (o=4) multi-beam exposure the overlap is a quarter of the beam size. Thus, for the case of 20 nm beam size the physical grid size is 5 nm. A discrete dose level can be assigned to each area of the physical grid, which is 5 nm × 5 nm for the example chosen; the line 72 in Fig. 10A indicates the superposition of the intensity (or total dose) as it is composed by the overlapping exposure spots with discrete dose levels assigned to the pixel positions for generating the 30 nm line, whereas for better visibility the blur has been set to zero (so that the dose distribution of a single exposure spot becomes a rectangle). If the blur has a realistic value, the step function at the edge of the rectangle is convoluted with a Gaussian function, which eventually transforms to a Gaussian shape. In that sense the line 72 can be seen as superposition of Gaussian functions at blur zero. In the general case the dose level histogram will not be symmetrical in order to position the left and right edge at predefined positions.

Fig. 10B shows a simulation for a line of 30.0 nm width, with the left edge to be positioned at 0.0 nm and the right edge at 30.0 nm. For the simulation, it was assumed that beam spots of 20 nm are exposed with 5.1 nm 1sigma blur (i.e., 12.0 nm FWHM blur). The intensity profile 76 is formed by overlapping the profiles of the exposure spots 73, 74, and 75. The dose level of the leftmost exposure spot 74 is adjusted such that the 30 nm line starts at the desired start position 77, i.e. at 0 nm. The dose level of the rightmost exposure spot 75 is adjusted such that exposed line ends at position 78 at 30.0 nm. As can be seen in Fig. 10B, in accordance with "quad-grid" exposure, the overlap of the exposure spots 73, 74, 75 is a quarter of the beam size, i.e. 5 nm.

Figs. 10c and 10D illustrate how the invention enables the MBW device to write lines with precise edge definitions; in each figure, the top frame shows the edge position error vs. line width, the middle frame the intensity profile, and the bottom frame shows the edge position deviation when enhancing the exposure dose by 10% vs. line width. Fig. 10A shows the intensity profile obtained for a 31.4 nm line width, and Fig. 10B for a 40.0 nm line width. Using the MBW with 20 nm beam size and quad-grid exposure (5 nm physical grid size), the line width of the structure generated by the exposure can be changed in steps of 0.1 nm. Because of the integer dose levels there are slight deviations from the 0.1 nm address grid. These deviations are indicated as "edge position error" (top frames), as functions of the desired line width, in 0.1 nm steps between 30.0 nm and 40.0 nm. As can be seen the deviations are within ±0.05 nm. Furthermore, the change of edge position with 10% change of dose is only approx. 1 nm, varying only slightly with change of line width as shown in the bottom frames. In other words, since the dose is controlled in a MBW to better than 1%, the change of edge position with 1% change of dose is within approx. one atomic layer.

Figs. 11A, 11B, and 11C show intensity profile diagrams illustrating how the multi-beam exposure methods illustrated here can achieve a fine positioning of structure feature with resolution smaller than the grid size. In the intensity profile diagrams, like those of Figs. 11A-C, the discrete dose levels are visualized as rectangles 64 of uniform height, piled up in a "brick-layer" arrangement; of course, this "brick-layer" depiction is only symbolical and intended to facilitate interpretation of the drawings.

Fig. 11A shows a dose level histogram, for the example of a line of 30nm width exposed by means of a 4bit (i.e., 15 dose levels per spot) exposure in a quad-grid with a beam spot size of 20nm width. The grid size 62 is 1/4 of the linear size of the exposure spots, which are symbolized as rectangles piled up in a "brick-layer" arrangement, and the resulting dose level distribution 65 is outlined as a bold line.

The line width can be made smaller or larger in very fine steps, which are smaller than the grid size, in this case the quad-grid size 62. Reducing the line width can be achieved by lowering the dose level of the outermost exposure spots and/or omitting exposure spots (the latter when the reduction is at least about one half of an exposure spot size). Increasing the line width can be achieved by enhancing the dose level of the outermost exposure spots and/or, in particular when the maximum dose level has been reached, by adding an additional, preferably overlapping, exposure spot. The latter aspect is illustrated in Fig. 11B: an exposure spot 66 having a defined dose level is added, resulting in a dose level histogram 67 for the line with larger width compared to 65. By combining these effects of decreasing and increasing on either side, there is also the possibility to shift the line position in very fine steps. Fig. 11c illustrates a shift of the line without changing the width, which is achieved by removing dose levels from spot 68 and adding dose levels from spot 69, resulting in the dose level histogram 70 which corresponds to a line shifted to the right as compared to the line of Fig. 11A.

The intensity profiles of Figs. 11A-C are shown along the X direction of the target plane. It is straightforward to extend the multi-beam exposure methods illustrated here to lines along other directions as well, and fine positioning can be achieved for lines at any angle on the target plane.

**Dose inhomogeneity correction**

As described by the applicant in US 2015/0347660 A1, it has been observed that in a typical embodiment of the invention, the current transmitted by each beamlet (or aperture) will not be uniform but may vary, mainly as a function of the distance to the optical axis cw (Fig. 1). This effect is due to imperfections in the charged particle source. Without further corrections, the dose a pixel receives will thus vary depending on the beamlet writing said pixel, leading to systematic edge placement errors.

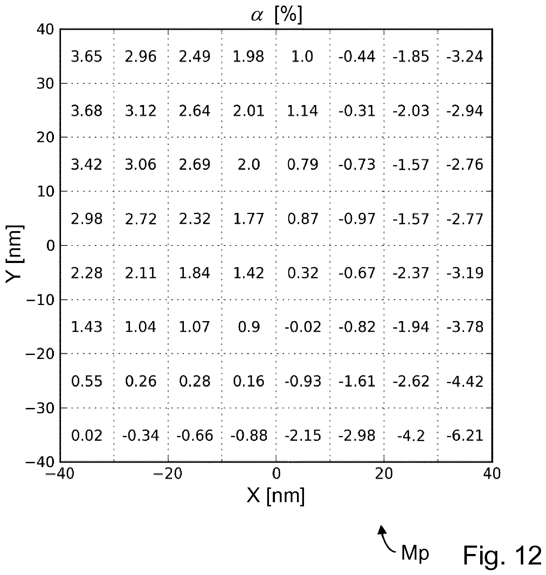

Fig. 12 is a typical example of a current density map Mp. More precisely, it shows a $8 \times 8$ coarse grained map of the deviation $\alpha(X,Y)$ (quantified in percentage [%]) of the current of a single beamlet located at a position/areal (X,Y) relative to the mean current across the image field. Typically, in the map the current dose values near the corners of the beam array are either reduced or enhanced with regard to the average over the map. In the example of Fig. 12 the beam array field of 82 $\mu$m $\times$ 82 $\mu$m at the target consisted of $512 \times 512 = 262,144$ programmable beamlets. As shown, a 8 $\times$ 8 matrix of the current dose distribution was measured, wherein each measured value comprises 262,144/64 = 16,384 beamlets used to generate the respective value. The electron source underlying Fig. 12 was of the type of a thermal field emission cathode with a flat emitter surface (single crystal, e.g. Tungsten or $LaB_6$). Since the electrons are emitted from a larger surface (typically 20 $\mu$m), it is unavoidable due to mechanical imperfection (e.g. alignment of emitter surface with respect to anode) or local differences in the extraction field strength, that the angular current density varies across the emitter.

To correct the observed dose variations, one suitable approach is to update the dose corresponding to a pixel by dividing by a homogenizing "dose correction factor" q depending on the beamlet writing said pixel, which is given by $q = C(1+\alpha)$, where $C = 1/[min_{[X,Y]} (1+\alpha(X,Y))]$ is a constant that fixes the minimum dose inhomogeneity correction factor at 1. (Here the symbol $min_{[X,Y]}$ stands for taking the minimum value among the values within the entire range of interest of X and Y coordinates.) This correction typically happens on-line as part of the data path.

**Data path**

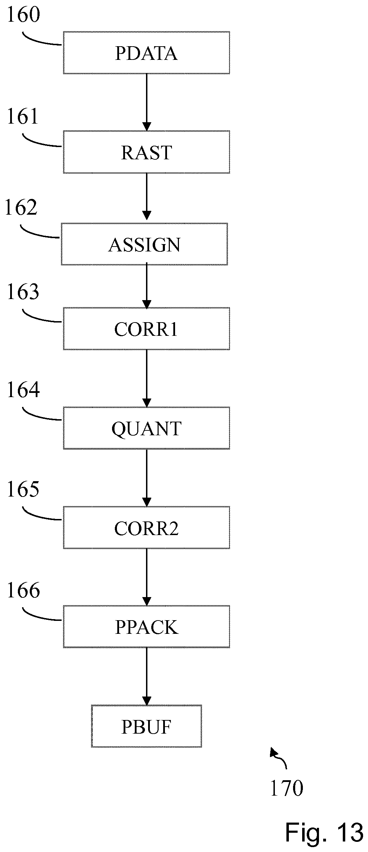

The part of the processing system 18 of the writer tool (Fig. 1) that converts the patterns to be written to beamlet dose assignments (as described above), which can be used in the writing process, is referred to as "data path" system. Fig. 13 shows a flowchart of the data path 170 in the context of the invention. The data path is preferably performed in real time; in a variant, part or all of the calculations of the data path may be performed in advance, for instance in a suitable computer.

The complete pattern image comprises a vast amount of image data, which is why for efficient computation of those data a high-speed data path that generates the pixel data to be exposed, preferably in real-time, will be suitable. The pattern to be exposed is typically described in a vector format, e.g. as a collection of geometries like rectangles, trapezoids or general polygons, which typically offers better data compaction and therefore reduces the requirements on data storage. The data path therefore consists of three major parts:

- a vector-based physical correction process (step 160),
- rasterization processes to translate the vector to pixel data (steps 161 to 164), and
- buffering of pixel data for temporary storage for the writing process (steps 165 and 166).

The data path starts upon being supplied a pattern PDATA to be exposed at step 160. In step 160, generally, the pattern PDATA to be exposed is split into a large number of small data chunks, possibly with geometric overlaps. Corrections that can be applied in the vector domain (e.g. proximity effect correction) may be carried out to all chunks independently, possibly in parallel, and the resulting data is sorted and coded in a way to improve computation speed of the following steps. The output is a collection of chunks where all chunks contain a collection of geometries.

Stage 161: Rasterization RAST. The geometries of every chunk are converted into rasterized pixel graphics. In this step, each pixel is assigned an floating-point gray scale intensity depending on the geometric overlap of the corresponding surface of the raster-grid cell with the pattern to be exposed, i.e. the entity of all associated chunks. This floating-point intensity represents the ideal physical exposure dose to be delivered onto the target at the respective pixel location. In more detail, every pixel that is completely inside a geometry is assigned the maximal intensity, whereas the intensity of pixels that crosses an edge of a geometry is weighted by the fraction of the area of the pixel that is covered by the geometry. This method implies a linear relation between the area of the geometry and the total dose after the rasterization.

Stage 162: Pixel-to-beamlet assignment ASSIGN. In this step, given a particular write sequence, it is determined which pixel will be written by which beamlet.

Stage 163: Pixel based corrections CORR1. In this step, all corrections that can be applied in the pixel domain are performed. These corrections comprise compensation of deviations from a uniform current density of the beam 50 over the aperture field (as described earlier and in US 9,495,499 of the applicant) and/or correction for individual defective beam deflectors in the DAP 30 (as in US 9,269,543 of the applicant). Pixel based corrections are realized by modifying the floating-point intensity of each individual pixel. This is being done with respect to the Pixel-to-beamlet assignment of Stage 162, which makes it possible to define and apply a compensation dose-factor q (or, equivalently a dose-shift s) for each pixel depending on by which beamlet it is written, and/or by which beamlets the neighboring pixels are written. Stage 164: Quantization QUANT. The quantization process converts the possibly corrected, floating-point intensity of each pixel into a quantized (or equivalently 'discrete') gray level, given a predetermined gray value scale.

Stage 165: Further optional pixel based corrections CORR2 in the gray-level pixel data domain may be applied (not part of the present invention).

Stage 166: Pixel packaging, PPACK. The pixel image obtained from stage 164 is sorted according to the placement grid sequence and sent to a pixel buffer PBUF which is provided in the processing system 18 of the writer tool (Fig. 1). The pixel data is buffered until a sufficient amount of data, typically at least the length of a stripe, is present, which triggers the exposure of the stripe (see Fig. 7). The data is taken out of the buffer during the writing process. After the stripe has been written, the process described above starts anew for the pattern data of the next region, such as the next stripe.

**Dose-level quantization**

The present invention pertains to the QUANT stage 164 of the data path, which converts the floating-point (or equivalently high-resolution) intensity data into a quantized (i.e. discrete) gray level scale. In a typical realization of the invention the gray-level data is finally represented by a low-bit code, i.e., a code expressed through a small number of data bits. For instance, in a scenario where every pixel is described by 4 bits, on pixels has $2^4$ = 16 possible configurations, i.e. $n_Y$=16 dose levels (0, 1, 2, ....,15). In a realization where the minimum dose 0% and the maximum dose 100% is equidistantly divided into 16 discrete dose levels, the step between two dose levels is 100%/15=6.67%.

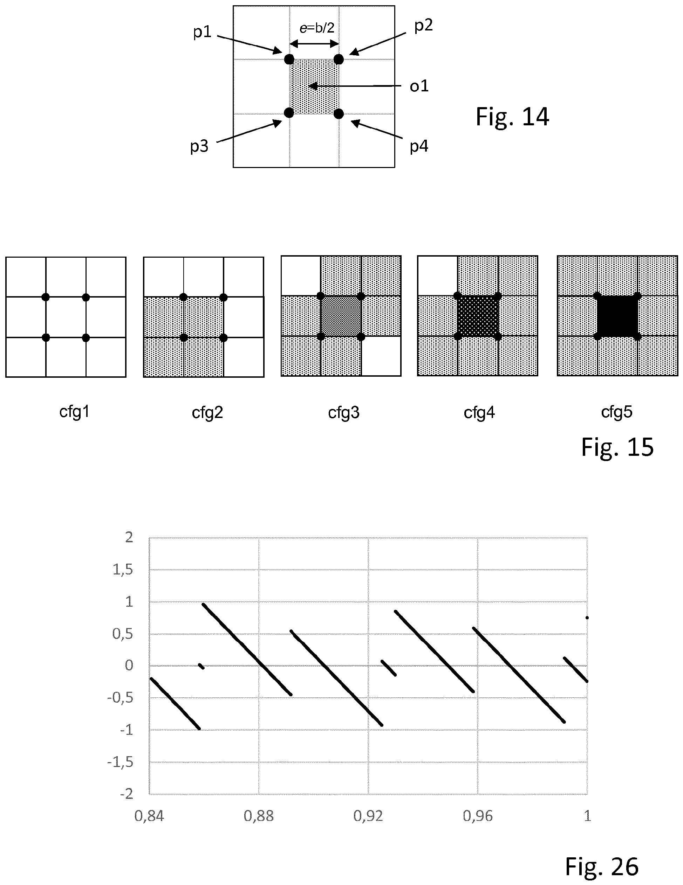

In order to achieve finer dose-steps a suitable approach exploits that for oversampling o>1 it is possible to improve the discretization by means of a dithering process. The main principle of altering the dose in steps finer than 6.67% is illustrated in Figs. 14 and 15. In Fig. 14, four neighboring pixels p1, p2, p3 and p4 for the example of double-grid oversampling (o=2) are shown. Since the pitch between neighboring pixels is e=b/2, each overlapping area of size $e^2 = b^2/4$ is simultaneously covered by four beamlets. As the individual pixels each carry a 4 bit wide information, there are now $4\times15+1$=61 possible dose levels. Thus, the dose on the substrate can effectively be altered in steps of 6.67%/4=1.67% in contrast to the 6.67% for the individual pixels. In Fig. 15, the dose of the overlapping area o1 in the middle (dashed area) is considered. Starting from dose zero on all four neighboring pixels cfg1, the dose-level of o1 is increased by one, resulting in configuration cfg2 where the dose in the overlapping area is now 1 out of 4x15=60 possible non-zero dose-level configurations. Thus, the overall dose has increased by only 1/60=1.67%. Fig. 15 shows all possible 4+1=5 dose configurations cfg1, cfg2, cfg3, cfg4, cfg5 of the overlapping area for the case of two-dose levels, e.g. the pair 0 and 1, for the individual pixels p1, p2, p3 and p4. The skilled person easily realizes that any of the 60 possible non-zero dose-levels can be obtained by a combination of 4 pixels with 15 non-zero dose-levels. The finer gray level scale achievable in the overlapping area will be referred to as "effective gray levels" in the following.

As the number of overlapping pixels only depends on the oversampling factor o, it is straightforward to compute the number of dose levels for any combination of oversampling o and gray-level n-bit resolution. In detail, the number of overlapping pixels is $o^2$, resulting in $o^2 \times(2^n-1)+1$ effective gray-levels in steps of $1/(o^2 \times(2^n-1)+1)$. Besides the mentioned cases of oversampling o=2 and bit-resolution n=4, another interesting scenario with respect to the implementation of the applicant is o=4 (so-called quad-grid-mode) and n=4, where $n_Y=4^2 \times(2^4-1)+1$=241 effective dose-levels are available, which can be varied in steps of 0.4167%. It will be evident to the skilled person that other combinations of o and n may be suitable depending on the individual implementation.

In practice, a computationally inexpensive algorithm is required which, starting from a desired floating-point pixel intensity, determines a proper discrete gray-level assignment for neighboring pixels. Besides the requirement of being computationally inexpensive, this algorithm will have to ensure that the entire range of $o^2 \times(2^n-1)+1$ effective dose-levels can be exploited.

**Quantization using ordered dithering**

Due to its ease of calculation and deterministic behavior, ordered dithering is a method particularly suited for dose level discretization. During ordered dithering quantization, for every pixel (aperture image position) the fractional gray level value of the nominal dose is compared against a threshold value in a regular pattern obtained from a Bayer index matrix which is used as dithering matrix. The dose is then rounded up to the next dose step if it surpasses the threshold and rounded down otherwise. In general, the relationship between threshold matrix $T$ and Bayer index matrix B (which describes the order in which beamlets are rounded up for increasing target dose) is given by

$$T_{ij} = \frac{2B_{ij} - 1}{2d^2} \quad (i, j = 1, \ldots, d)$$

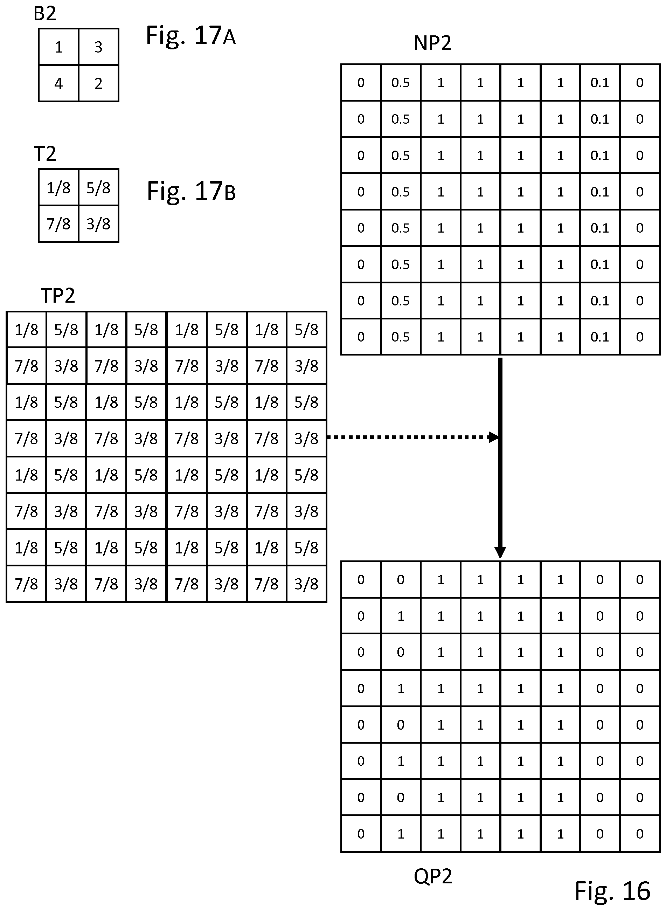

where d is the dithering order, i.e., the size of the dithering matrix $B$, which is usually quadratic. The dithering order d may be conveniently chosen equal to the oversampling factor o. Given the fundamental Bayer matrix B2 of Fig. 17A, Bayer matrices of arbitrary dimensions which are powers of two can be calculated recursively, namely, starting from the $2 \times 2$ matrix $B_2$ = B2 and using the recursion rule

$$B_{2n} = \begin{pmatrix} 4 \times (B_n - 1) + 1 & 4 \times (B_n - 1) + 3 \\ 4 \times (B_n - 1) + 4 & 4 \times (B_n - 1) + 2 \end{pmatrix}$$

where $B_n$ is a Bayer matrix of dimension n $\times$ $n$.

A simplified example for the application of a dithering matrix for rounding is presented in Fig. 16, relating to the case of two pixel gray levels (that is, every pixel has 1-bit data; thus, it can only be switched on or off) and double-dithering (i.e. d=2). The array NP2 represents an example of a desired pattern, in which each entry contains a value of the dose to be exposed at the respective area element on the target (target dose values, also referred to as nominal dose values); in the example shown, the array contains several instances of values 0, 0.1, 0.5, and 1. Fig. 17A shows a dithering matrix B2 of size 2×2 for d=2, and Fig. 17B shows the threshold matrix T2 resulting from the dithering matrix B2. The threshold matrix T2 is tiled in the plane in a regular pattern to obtain the threshold pattern TP2 (left-hand part of Fig. 16). The dimensions of the threshold pattern TP2 will suitably conform to the dimensions of the desired pattern array NP2 (top of Fig. 17). According to the dithering procedure, rounding is achieved in that the nominal dose value in each entry of the pattern NP2 is compared with the corresponding entry of the threshold pattern TP2, resulting in a quantized array QP2, which contains an array of dose values quantized so as to conform to the available gray values. In this example, the nominal dose values of 0.5 (half a pixel gray level) are rounded up and down in an alternating pattern, whereas doses of 0.1 are rounded down everywhere. The other dose values which occur in the target dose, i.e. 0 and 1, remain unchanged since they exactly match a pixel gray level.

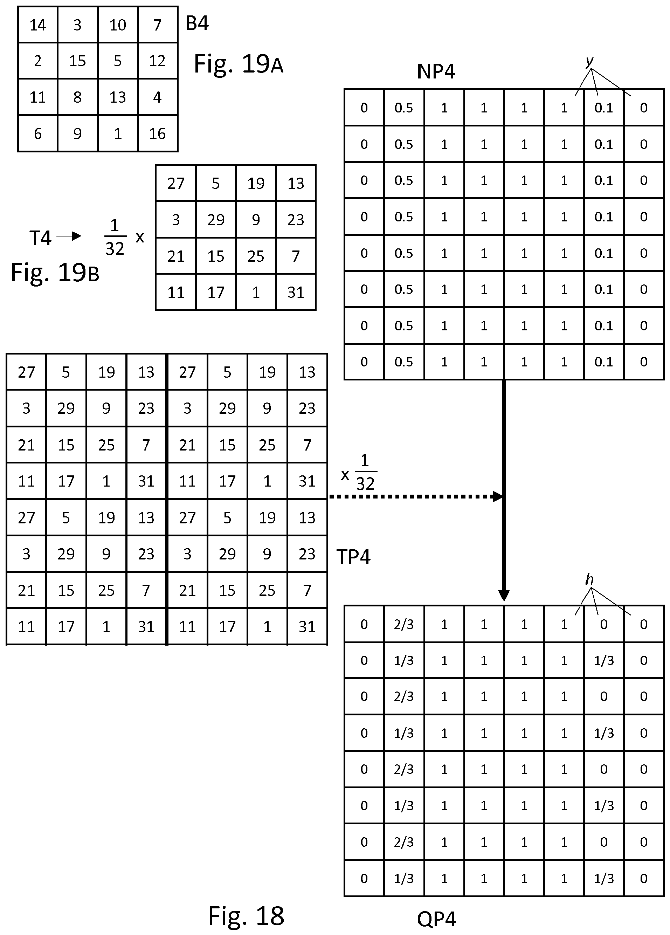

Another example is given in Figs. 18, 19A, and 19B for the same target pixel doses y in a pattern array NP4, but using quad-dithering (d=4) with a 4×4 dithering matrix B4 (Fig. 19A), and 4 (2-bit) pixel gray levels. The 2-bit information of one gray value means that a the available discrete gray values h form a palette having $2^2$ = 4 values, for instance, 0 (zero), 1/3, 2/3, and 1; each element will be assigned a quantized value h chosen from the palette based on the original pattern. Fig. 19B shows the threshold matric T4 which is calculated from the dithering matrix B4, and in Fig. 18 the resulting threshold pattern TP4 is illustrated. During the process of dithering from the desired pattern array NP4 to the quantized array QP4, the nominal dose values of 0.5 are rounded in an alternating pattern to the next pixel gray levels of 1/3 and 2/3, since the remainder of the subtraction 0.5-1/3=1/6, when divided by the step-size of the gray scale, i.e. 1/3, gives 3/6, which is larger than 5/32 and 15/32, but smaller than 20/32 and 17/32. Similarly, half of the pixel dose values of 0.1 are rounded up to 1/3 (since 0.1/(1/3)=0.3 is greater than 9/32 and 1/32) and the other half are rounded down to 0 (since 0.3 is smaller than 19/32 and 25/32). It is to be noted that the values of the entries shown in the matrices T4 and TP4 are scaled by an overall factor of 1/32 (indicated outside the respective matrix).

The general procedure for arbitrary dithering order d and bits per pixel n is as follows:

1. Decompose every nominal dose value into the form y = c*k + r, where the dividend k is the step-size, i.e. the step width of the gray scale, as determined by the number of bits n, i.e. k=1/($2^n$-1), and where the integer quotient c and (positive real-valued) remainder r are determined uniquely according to the Euclidean division theorem. In particular, the quotient c is a non-negative integer, and the remainder is a non-negative number r<k.

2. Compare the value v=r/k with the associated entry of the dithering threshold matrix. If this value v is larger than the entry from the dithering threshold matrix, the pixel is a assigned the discrete grey-level h = (c+1)*k; whereas if v is less than or equal to said threshold value, the pixel is assigned the discrete grey-level h = c*k.

Thus, in the second step, a floating point nominal dose value y (unless it already coincides with one of the values in the gray scale palette) is either rounded up or down, relative to the discrete grey-level scale with step-size k.

**Ordered dithering and dose corrections**

The combination of oversampling, dose corrections and ordered dithering can lead to complex stochastical effects. For the following examples, we consider the case of double-grid exposure (o=2) and $n_Y$=16, i.e. 16 gray levels (4-bit) for every pixel/beamlet and double-dithering (using the dithering matrices of Figs. 17A+B). As in Fig. 14, an overlapping area o1 is exposed by four overlapping aperture image positions p1, p2, p3, p4, giving a total of 61 gray levels. Since this corresponds to dose increments of 1/60=1.67%, the maximal dose error due to quantization is 0.84% (1/2 effective gray level or 1/8 pixel gray level) when using optimal rounding. When using ordered dithering for quantization, this error may become larger, particularly in the presence of inhomogeneous beam current and corresponding corrections as described earlier.

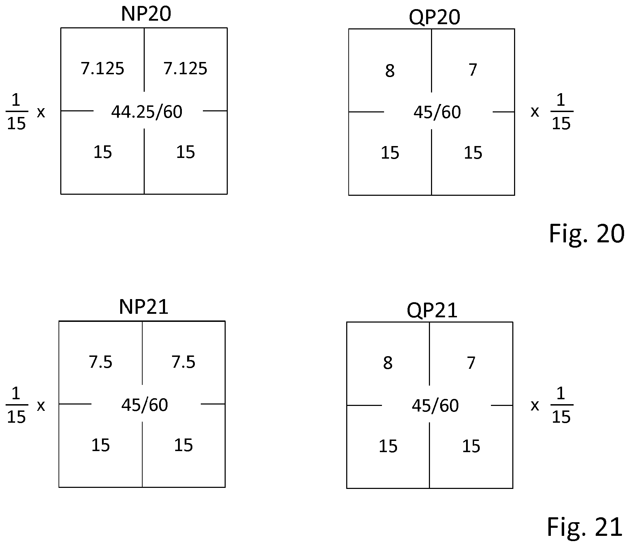

Fig. 20 gives an example for the case of homogeneous beam current. Consider a typical use-case, where a line through the upper half of the overlapping area o1 is to be exposed, as illustrated in the target dose array NP20. The beamlets at pixels p3, p4 are to deliver a maximal dose of 1, and the beamlets at p1, p2 a dose of 7.125/15=0.475 to produce a total o1 dose of 44.25/60=0.7375 of the maximal overlap dose 4. Applying the dithering matrix to obtain the quantized array QP20, the pixel p1 is rounded up to the next discrete gray level 8, whereas the pixel p2 is rounded down to 7; the pixels b3, b4 remain unchanged. The two roundings combine to an overlap dose error of 0.75/60=1.25% (which experimentally corresponds to a line edge placement error in the order of approx. 0.4 nm).

While in this example, the rounding error is larger than the ideal quantization error, it is the worst case scenario when writing a line with this dithering matrix and homogeneous beamlet doses. Also note that this is not a generic error that occurs when using ordered dithering, which means that there are also cases where there is no rounding error at all. Consider for example the case in Fig. 21. Here, the target dose value (array NP21) for the overlapping area o1, namely 45, is exactly matched when using the ordered dithering process as visible from the resulting quantized array QP21, even though the target dose of pixels p1, p2 lies between two discrete values; namely 7 and 8.

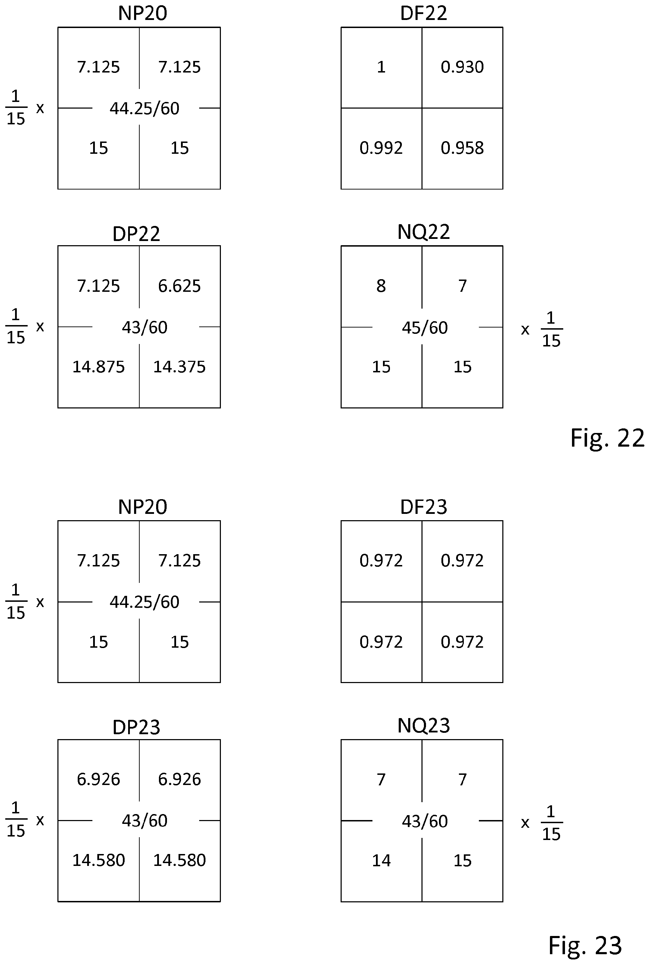

In the case of inhomogeneous beamlet current the rounding behavior can be much worse. This is due to the fact that the corrected doses may align with the dithering thresholds in an unfavorable way. An example is given in Fig. 22, comprising the same target dose values NP20 as in the case of Fig. 20, but with additional dose inhomogeneity correction factors. While the target dose is the same as in Fig. 20, due to the fact that the beamlets carry different amounts of current, the doses assigned to each pixel have to be adjusted with beamlet-dependent dose factors DF22 to effectively deliver the target doses DP22. Each pixel is now assigned an individual corrected dose, which, in some cases, can align unfavorably with the dithering thresholds. In Fig. 22, the worst possible rounding behavior is shown in the array NQ22 (all pixels are rounded up), leading to a total dose error of approximately 3.3% (45-43=2 out of 60 non-zero effective gray levels, or, equivalently 1/2 single pixel gray level), which, for the MBMW of the applicant, may experimentally correspond to an edge placement error of about 1.32 nm. This dose error also approximately remains in the effective dose (i.e., accounting for the different beamlet currents).

The above scenario can be resolved by using the same (or in practice: very similar) dose correction values for overlapping pixels which undergo the dithering process. Consider, for example, Fig. 23. Here, a common dose-correction-factor 0.972 (array DF23 has a uniform value) among the neighboring beamlets is applied which preserves the exact target dose, as can be seen in arrays DP23 and NQ23. That is, in the quantized dose distribution NQ23 the target dose of overlap o1 is still 43 as before, but with the advantage that when the ordered dithering is applied, no rounding error occurs at all.

Fig. 26 shows a plot of the rounding errors (in terms of effective gray levels) for the target dose values from Figs. 20 to 23 for the range 0.84 to 1.0 of common dose-correction factors for the four neighboring, and potentially overlapping pixels. Here, one can clearly observe that the worse-case rounding error of two effective gray levels does not occur. Instead, the maximal error is halved to one effective gray level.

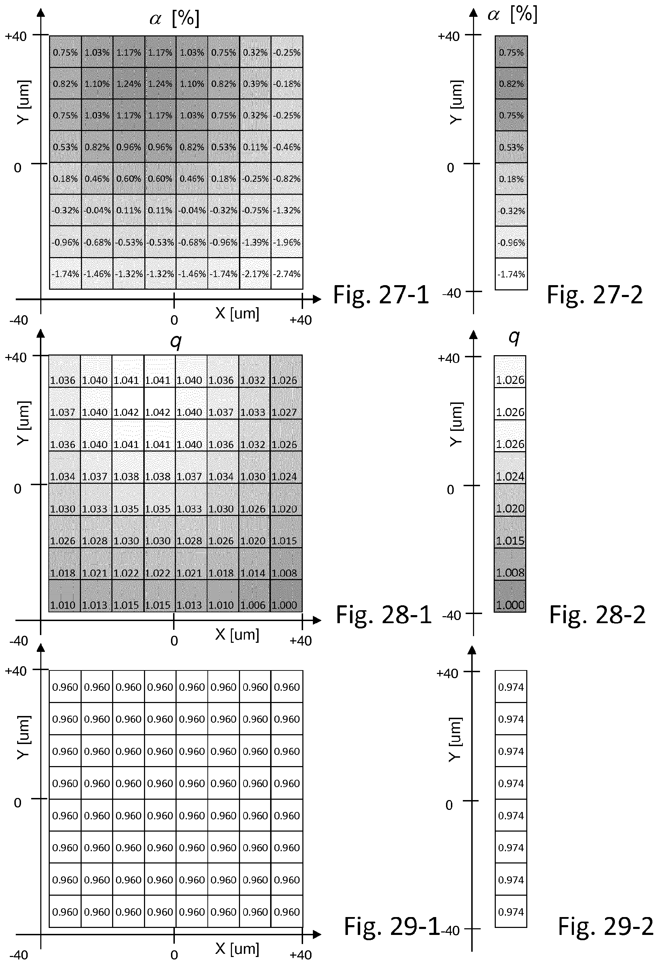

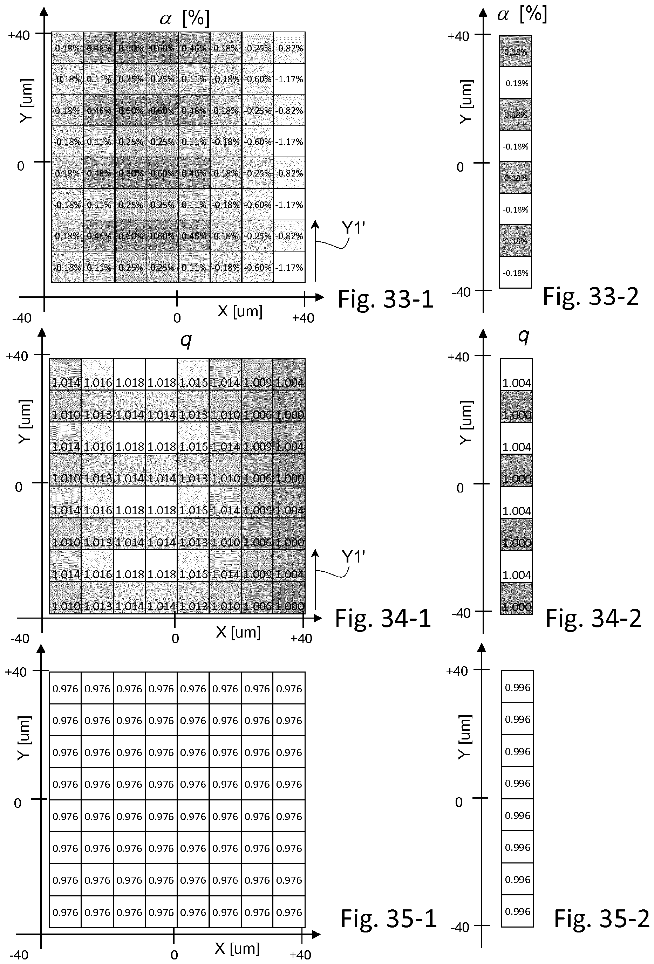

The invention is illustrated in Figs. 27-1 to 35-2, which allows an advantageous behavior of dose correction factors during dithering by using a uniform dose correction for each aperture-line along the write direction (i.e., the scanning direction sd, see Fig. 3). Fig. 27-1 shows a typical case of a current profile (more exactly, current density profile) across the image-field of size 80 $\mu$m $\times$ 80 $\mu$m, each value representing the deviation $\alpha(X,Y)$ (quantified in percentage [%]) of the current of a single beamlet located at the position (X,Y) of a respective area, relative to the mean current across the image field. The values listed in Fig. 27-1 depict a typical distribution according to a realistic scenario, with a roughly parabolic overall characteristic and a deviation range of several per cent. Corresponding normalized correction dose factors q (see above, Section 'Dose inhomogeneity correction') are given in Fig. 28-1, which are proportional to the multiplicative inverse of the doses from Fig. 27-1. Fig. 29-1 shows the corrected dose profile: applying the factors from Fig. 28-1 to the measured doses shown in Fig. 27-1 yields a completely flat dose profile of constant value 0.960. Note that the overall dose is now lower by a constant 4% across the whole image-field. This decrement, however, can easily regained by increasing the overall source current by the corresponding amount.

The data in Figs. 27-1 to 29-1 relate to the current profile, which corresponds to a (fictitious) pattern profile of uniform gray level y=1. In the case of a realistic pattern profile, where each of the pixels will receive an individual gray level value y with $0 \le y \le 1$ (nominal dose value), the correction dose factors q are used to correct these nominal dose values y so as to compensate for the non-ideal current profile (Fig. 27-1). This is done by dividing each nominal dose value y by the value q of the respective beamlet (Fig. 28-1), so as to obtain a corrected dose value $y' = y/q$. This correction is made for each beamlet (i.e., each pixel or image element on the target) of the entire image field.

In order to avoid that the unfavorable worst-case rounding occurs, one computes the averaged dose profile along the scanning direction sd, which in this example is the X-axis. Re-normalized, this yields the effective dose-values shown in Fig. 27-2, which can be corrected via the dose-correction factors given in Fig. 28-2. Overall, the mean dose-intensity is reduced to the common value 0.974 as shown in Fig. 29-2. This is another advantage, namely that the minimum dose correction factor q is larger due to this averaging. This has the effect that more effective dose levels are available for writing a pattern, because the lower this number is, the more gray-levels are effectively needed for dose-inhomogeneity-correction.

While the worst-case rounding behavior (of two effective gray levels) described earlier only occurs by chance, it may appear systematically if an overlapping stripe strategy (=multipass) is applied as described in US 9,053,906 B2. Consider again a double-grid double-dithering strategy with ordered dithering discretization as illustrated in Fig. 14. In addition, a double-pass writing strategy as described previously is applied, according to which the pixels p1, p4 will typically be written in one pass, whereas the pixels p2, p3 are written in the other pass. Pixels written in the same pass tend to have similar dose factors (as they originate from the same y-position of the charged particle source), or have already been equalized according to previously introduced method. Due to the structure of the dithering matrix, the pixels p1, p4 are more likely to be rounded up, whereas p2, p3 tend to be rounded down, leading to an intricate correlation between the dose factors and the rounding behavior, which under certain circumstances can introduce systematic edge placement errors across the beam-field when exposing a regular pattern.

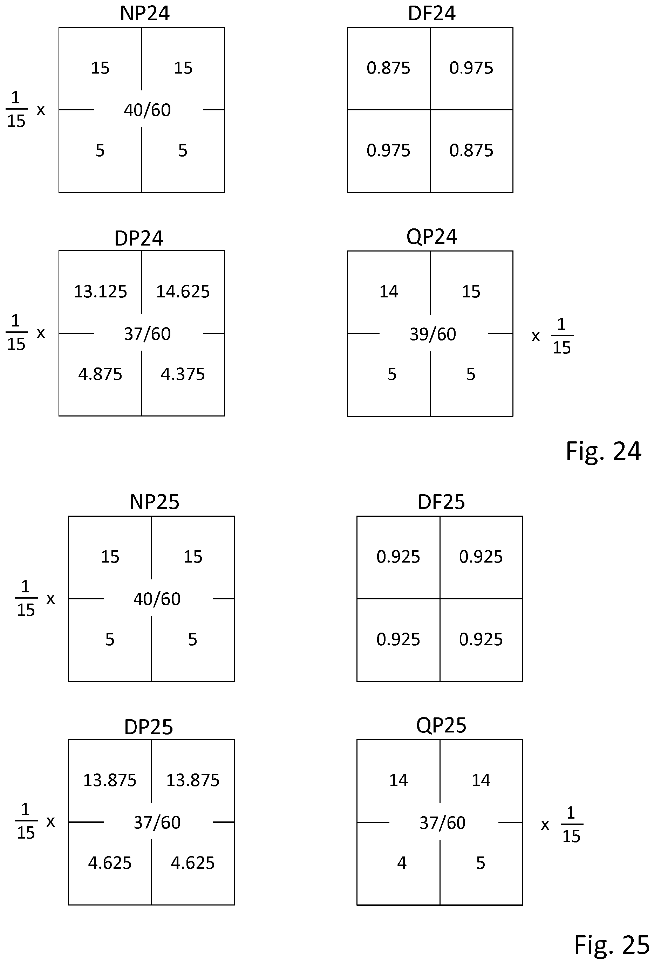

An example is given in Fig. 24; the reference symbols correspond to those of Figs. 22 and 23 mutatis mutandis. As before, the beamlets are assigned individual dose correction factors q, however, in this case a correlation between the dose factors and the dithering matrix arises. The solution presented in Figs. 27 to 29, in which a common dose correction factor q is assigned to each aperture line improves the situation, but not to a satisfactory amount, because pixels p1, p4 and p2, p3 may now be written by beamlets from different aperture rows. Consequently, only two of the four dose factors will be identical. In this case, the maximal rounding error is again four times as large as the ideal quantization error with 3.33% (two effective gray levels). In some constellations, the error can be additionally increased due to the fact that beamlets from one pass now have the tendency to get rounded down, whereas for the other pass it is more likely that the beamlet is rounded up. In the example given in Fig. 24, for instance, the high-dose-factor beamlets have the tendency to be rounded down and low-dose-factor beamlets the tendency to be rounded up, leading to observable systematic CD errors with respect to the Y-position of a stripe.

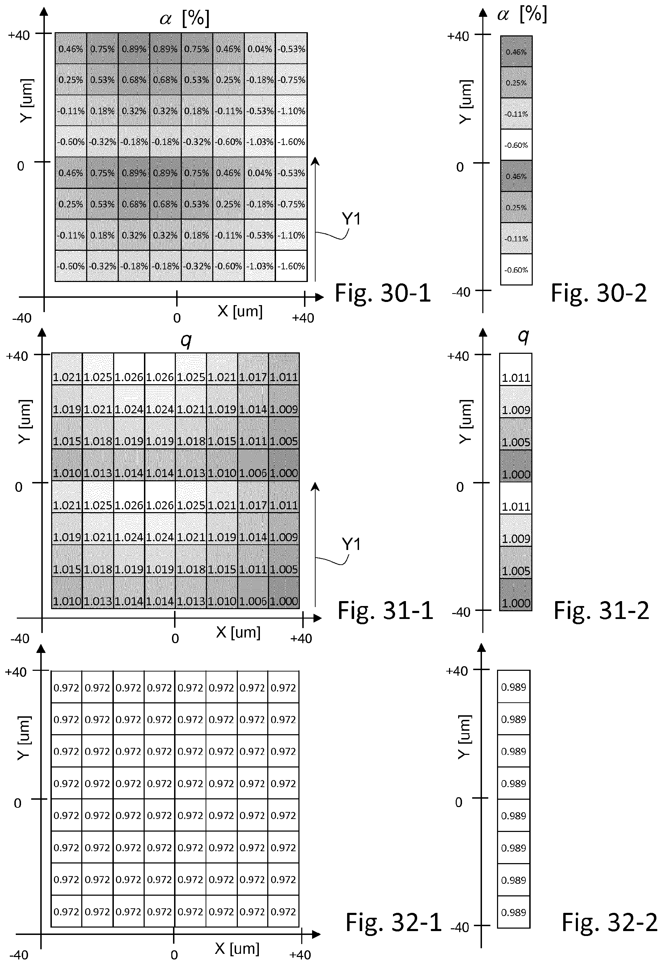

According to the invention, the solution to this problem is presented in Figs. 30-1 to 32-2. First, an effective dose-profile is computed by averaging the dose profile $\alpha(X,Y)$ (quantified in percentage [%] of the current of a single beamlet located at a position (X,Y) relative to the mean current across the image field) according to the (multipass) stripe overlap (compare with Fig. 8A and Fig. 8B). This stripe overlap is determined by the offset Y1 between overlapping stripes, Y1 = y0/2. Fig. 30-1 shows the deviation $\alpha(X,Y)$ of the effective dose-profile from the mean value in per cent. For this effective dose-profile, one then computes the corresponding correction factors, as illustrated in Fig. 31-1. Optionally, the factors are additionally equalized along the X-direction, analogously, as for the non-overlapping stripe-exposure mode; this leads to the effective dose correction factors as illustrated in Figs. 30-2 and 31-2. In particular, using the common correction factors as depicted in Figs. 31-2 in the double-pass mode, where stripes from different passes overlap with 50% of their width (as also shown in Figs. 8A and 8B), a maximal rounding error of 1 effective gray level is achieved, since the neighboring pixels from different passes now have the same dose correction factor $q$, as e.g. depicted in Fig. 25.

It is straightforward to generalize the procedure described above to other scenarios. For instance, the quad-pass variant is illustrated in Figs. 33-1 to 35-2. Here, the offset Y1' between overlapping stripes is 1/4 of the stripe width y0, and every second image-field segment is averaged in Y-direction, corresponding to four passes; in other respects, the Figs. 33-1 to 35-2 correspond to those of Figs. 30-1 to 32-2, respectively. Note again, that the minimum dose correction factor over the image-field becomes larger the more averaging is performed.

**Claims**

1. A method for irradiating a target with a beam of energetic radiation formed by electrically charged particles for writing a desired pattern on said target, comprising the steps of

   - providing a pattern definition device (4) having a plurality of apertures (24) transparent to said radiation,
   - illuminating said pattern definition device by means of an illuminating wide beam (lb), which traverses the pattern definition device through said apertures thus forming a patterned beam (pb) consisting of a corresponding plurality of beamlets (51),
   - forming said patterned beam into a pattern image (pm) on the location of the target (17), said pattern image comprising the images (b1) of at least part of the plurality of apertures covering a number of pattern pixels (px), i.e. aperture image positions, on the target, wherein during a sequence of exposure intervals, each of the apertures is selectively controlled so as to impart respective dose amounts to the pattern pixels (px), in the following also merely referred to as pixels, onto which the respective aperture is imaged, said dose amounts (y) being selected in accordance with the desired pattern, where each pixel is associated with a nominal dose amount (y) in accordance with the desired pattern,

- generating a relative movement between said target (16) and the pattern definition device (4) producing a stepwise movement of said pattern image on the target along a path over a region (r1, Rr) where a beam exposure is to be performed, said path being composed of sections which extend along a scanning direction (sd), said sections corresponding to exposure stripes (s11, s12, s13; s20, s21, s22) covering said region in sequential exposures, wherein the exposure stripes (s11, s12, s13; s20, s21, s22) are mutually overlapping wherein overlapping exposure stripes are located at different transversal offsets as taken along a direction (Y) transversal to the scanning direction, such that each area of said region is exposed by at least two different areas of the pattern image at different transversal offsets (Y1),

- calculating, by an electronic pattern information processing system (18), for each pixel, a corrected dose amount ($y'$) by dividing the value of the nominal dose amount ($y$) by a correction factor ($q$), **characterised in that**

the same correction factor ($q$) is used with pixels written by beamlets located at positions which differ only by said transversal offsets (Y1) of overlapping stripes, while the correction factor ($q$) varies between groups of pixels which differ by an offset which does not correspond to a transversal offset (Y1) of overlapping stripes.

2. The method of claim 1, wherein during the step of calculating a corrected dose amount for each pixel,

- an available current density at the respective pixel is determined, wherein said maximum available current density is determined as the actual current density of the irradiating beam radiated through the aperture corresponding to the respective pixel,
- said correction factor ($q$) of the respective pixel is calculated as the ratio of said available current density to the minimum current density across the overall beam array field, and
- correction factors ($q$) are averaged among those pixels that are located at positions which differ only by said transversal offsets (Y1) of overlapping stripes.

3. The method of claim 1 or 2, further comprising

- multiplicative renormalization of the correction factors ($q$),

using a renormalizing factor chosen such that one of the largest value and the smallest value of the correction factors is renormalized to 1.

4. The method of any one of claims 1 to 3, wherein the step of calculating a corrected dose amount for each pixel comprises calculating, for each pixel in a row of pixels parallel to the scanning direction within a respective exposure stripe, corrected dose amounts ($y'$) by dividing the values of the dose amounts by a row correction factor ($q$), wherein said row correction factor is uniformly applied to all pixels of a row of pixels.

5. The method of claim 4, wherein said row correction factor ($q$) is calculated for a respective row of pixels based on the values of current dose actually radiated through a series of apertures, said series of apertures containing all apertures within the pattern definition device (4) which impart dose amounts to the respective row of pixels, wherein the row correction factor ($q$) of a row of pixels is calculated as the ratio of actual current dose of an aperture, as averaged over the corresponding series of apertures, to a nominal current dose value assumed to be constant over the plurality of apertures (24) of the pattern definition device (4).

6. The method of any one of claims 1 to 5, wherein said region (Rr) where a beam exposure is to be performed is composed of a plurality of pattern pixels (px) arranged in a regular arrangement, said region having a total width (Ry) as measured across said scanning direction (sd), said exposure stripes within said region running substantially parallel to each other along said scanning direction and having uniform widths (y0) as measured across said scanning direction.

7. The method of claim 6, wherein the exposure stripes (s11, s12, s13; s20, s21, s22) are mutually overlapping, the position of the stripes differing by a transversal offset (Y1) in a direction across the scanning direction, wherein the row correction factors of rows of pixels are averaged over those rows of pixels which are offset to each other by said transversal offset (Y1).

8. The method of claim 1, including computing an exposure pattern suitable for exposing the desired pattern on a target (16) using said pattern definition device (4) for writing said desired pattern by exposing a multitude of pixels (px) within said region (r1, Rr) on the target, wherein during exposing the desired pattern on a target:

- in said pattern definition device said plurality of blanking apertures (24, 33, 43) is arranged in a predetermined arrangement defining mutual positions of the blanking apertures, each blanking aperture being selectively adjustable with regard to a dose value to be exposed through the respective blanking aperture onto a corresponding aperture image on the target during a respective exposure interval, said dose value taking a respective value in accordance with a discrete palette, said discrete palette including a number of gray values (h) forming a scale ranging from a minimum value to a maximum value,
- during a writing process of said desired pattern, a sequence of exposure intervals (T1) is made, wherein in each exposure interval the blanking apertures are imaged onto the target (16), thus generating a corresponding plurality of aperture images (b1, bi0, bi1), wherein the position of aperture images is kept fixed relative to the target at the position of a pixel during an exposure interval, but between exposure intervals the position of aperture images is shifted over the target, thus exposing the multitude of pixels on the target, and
- the aperture images are mutually overlapping on the target, and the aperture images have a nominal width (b) which is greater than the distance (e) between pixel positions of neighboring aperture images on the target, by an oversampling factor (o) greater than one,

wherein computing the exposure pattern comprises:

(i) determining the discrete palette,
(ii) providing the desired pattern and calculating a nominal exposure pattern as a raster graphics (NP2, NP4) defined on the multitude of pixel elements, said nominal exposure pattern being suitable to create a nominal dose distribution on the target realizing contour lines of the desired pattern and including for each pixel element a respective nominal dose amount (y), and
(iii) determining, for each pixel element, a discrete value (h) which approximates the nominal dose amount (y) of the respective pixel element, said discrete value being selected from the discrete palette,

wherein in step (iii), determining the discrete values includes employing ordered dithering using a dither matrix (T2, T4) of a predefined size (d).

9. The method of claim 8, wherein the dither matrix (T2, T4) is a Bayer matrix.

**Patentansprüche**

1. Verfahren zum Bestrahlen eines Targets mit einem Strahl energiereicher Strahlung gebildet aus elektrisch geladenen Teilchen, um ein gewünschtes Muster auf das Target zu schreiben, mit den Schritten

- Bereitstellen einer Musterdefinitionsvorrichtung (4) mit einer Vielzahl von Aperturen (24), die für die Strahlung transparent sind,
- Bestrahlen der Musterdefinitionsvorrichtung mittels eines breiten Beleuchtungsstrahls (lb), der die Musterdefinitionsvorrichtung durch die Aperturen durchläuft und dadurch einen strukturierten Strahl (pb) bildet, der aus einer entsprechenden Vielzahl von Strahlenbündeln (51) besteht,
- Formen des strukturierten Strahls in ein Musterbild (pm) am Ort des Target (17), wobei das Musterbild die Bilder (b1) von zumindest einem Teil der Vielzahl von Aperturen umfasst, die eine Anzahl von Musterpixels (px), d.h. Positionen von Aperturenbildern, auf dem Target überdecken,
wobei während einer Folge von Belichtungsintervallen jede der Aperturen selektiv so gesteuert wird, dass den Musterpixels (px) - im Folgenden auch nur als Pixels bezeichnet - auf die die jeweilige Apertur abgebildet wird, jeweilige Dosismengen (y) zugeführt werden, die gemäß dem gewünschten Muster ausgewählt werden, wobei jedem Pixel eine nominale Dosismenge (y) gemäß dem gewünschten Muster zugeordnet ist,
- Erzeugen einer Relativbewegung zwischen dem Target (16) und der Musterdefinitionsvorrichtung (4), die eine schrittweise Bewegung des Musterbildes auf dem Target entlang eines Pfades über ein Gebiet (r1, Rr) erzeugt, in dem eine Strahlungsbelichtung durchgeführt werden soll, wobei der Pfad aus Abschnitten zusammengesetzt ist, die entlang einer Abtastrichtung (sd) verlaufen, wobei diese Abschnitte Belichtungsstreifen (s11, s12, s13; s20, s21, s22) entsprechen, die das Gebiet in aufeinanderfolgenden Belichtungen abdecken,
wobei die Belichtungsstreifen (s11, s12, s13; s20, s21, s22) einander überlappen, wobei überlappende Belichtungsstreifen entlang einer Richtung (Y) quer zur Abtastrichtung in unterschiedlichen transversalen Versätzen angeordnet sind, so dass jeder Bereich des Gebiets durch zumindest zwei unterschiedliche Bereiche des Musterbildes mit unterschiedlichen transversalen Versätzen (Y1) belichtet wird,

- Berechnen einer korrigierten Dosismenge (y') für jedes Pixel durch ein elektronisches Musterinformationsverarbeitungssystem (18) dadurch, dass der Wert der nominalen Dosismenge (y) durch einen Korrekturfaktor (y) geteilt wird, **dadurch gekennzeichnet, dass** derselbe Korrekturfaktor (q) bei Pixels verwendet wird, die von Strahlenbündeln geschrieben werden, die sich an Positionen befinden, die sich nur durch die transversalen Versätze (Y1) von überlappenden Streifen unterscheiden, während der Korrekturfaktor (q) zwischen Gruppen von Pixels variiert, die sich durch einen Versatz unterscheiden, der nicht einem transversalen Versatz (Y1) von überlappenden Streifen entspricht.

2. Verfahren nach Anspruch 1, wobei während des Schritts des Berechnens einer korrigierten Dosismenge für jedes Pixel

- eine verfügbare Stromdichte an dem jeweiligen Pixel bestimmt wird, wobei die maximal verfügbare Stromdichte als die tatsächliche Stromdichte des Strahlenbündels festgelegt wird, das durch die dem jeweiligen Pixel entsprechende Apertur eingestrahlt wird,
- der Korrekturfaktor (q) des jeweiligen Pixels als das Verhältnis der verfügbaren Stromdichte zur minimalen Stromdichte über das gesamte Strahlenarrayfeld berechnet wird, und
- die Korrekturfaktoren (q) zwischen jenen Pixels gemittelt werden, die sich an Positionen befinden, die sich nur durch die transversalen Versätze (Y1) der überlappenden Streifen unterscheiden.

3. Verfahren nach Anspruch 1 oder 2, ferner umfassend

- multiplikative Renormierung der Korrekturfaktoren (q),

unter Verwendung eines Renormierungsfaktors, der so gewählt wird, dass der größte Wert oder der kleinste Wert der Korrekturfaktoren auf 1 renormiert ist.

4. Verfahren nach einem der Ansprüche 1 bis 3, wobei der Schritt des Berechnens einer korrigierten Dosismenge für jedes Pixel das Berechnen korrigierter Dosismengen (y') für jedes Pixel in einer Zeile von Pixels parallel zur Abtastrichtung innerhalb je eines Belichtungsstreifens durch Dividieren der Werte der Dosismengen durch einen Zeilenkorrekturfaktor (q) umfasst, wobei der Zeilenkorrekturfaktor einheitlich auf alle Pixel einer Zeile von Pixels angewendet wird.

5. Verfahren nach Anspruch 4, wobei der Zeilenkorrekturfaktor (q) jeweils für eine Zeile von Pixels aufgrund der Werte der aktuellen Dosis berechnet wird, die tatsächlich durch eine Reihe von Aperturen ausgestrahlt wird, wobei die Reihe von Aperturen alle Aperturen in der Musterdefinitionsvorrichtung (4) enthält, die Dosismengen an die jeweilige Zeile von Pixels weitergeben, wobei der Zeilenkorrekturfaktor (q) einer Zeile von Pixels als das Verhältnis der tatsächlichen Stromdosis einer Apertur, gemittelt über die entsprechende Zeile von Aperturen, zu einem nominalen Stromdosiswert berechnet wird, der als konstant über die Vielzahl von Aperturen (24) der Musterdefinitionsvorrichtung (4) angenommen wird.

6. Verfahren nach einem der Ansprüche 1 bis 5, wobei das Gebiet (Rr), in dem eine Strahlungsbelichtung durchgeführt werden soll, aus einer Vielzahl von Musterpixels (px) besteht, die in einer regelmäßigen Anordnung angeordnet sind, wobei das Gebiet eine Gesamtbreite (Ry) gemessen quer zur Abtastrichtung (sd) aufweist, wobei die Belichtungsstreifen innerhalb des Gebiets im Wesentlichen parallel zueinander entlang der Abtastrichtung verlaufen und einheitliche Breiten (y0) quer zur Abtastrichtung gemessen aufweisen.

7. Verfahren nach Anspruch 6, wobei die Belichtungsstreifen (s11, s12, s13; s20, s21, s22) einander überlappen, wobei sich die Position der Streifen um einen transversalen Versatz (Y1) in einer Richtung quer zur Abtastrichtung unterscheidet, wobei die Zeilenkorrekturfaktoren von Pixelzeilen über jene Pixelzeilen gemittelt werden, die um den transversalen Versatz (Y1) zueinander versetzt sind.

8. Verfahren nach Anspruch 1, umfassend das Berechnen eines Belichtungsmusters, das zum Belichten des gewünschten Musters auf einem Target (16) unter Verwendung der Musterdefinitionsvorrichtung (4) zum Schreiben des gewünschten Musters durch Belichten einer Vielzahl von Pixels (px) innerhalb des Gebiets (r1, Rr) auf dem Target geeignet ist,

wobei während des Belichtens des gewünschten Musters auf ein Target:

- in der Musterdefinitionsvorrichtung die Vielzahl von Blanking-Aperturen (24, 33, 43) in einer vorbestimmten Anordnung angeordnet ist, die Positionen der Blanking-Aperturen zueinander definiert, wobei jede Blanking-Apertur selektiv in Bezug auf einen Dosiswert einstellbar ist, der durch die jeweilige Blanking-Apertur auf ein entsprechendes Aperturenbild auf dem Target während eines jeweiligen Belichtungsintervalls zu belichten ist, wobei der Dosiswert jeweils einen Wert gemäß einer diskreten Palette annimmt, wobei die diskrete Palette eine Anzahl von Grauwerten (h) enthält, die eine von einem Minimalwert bis zu einem Maximalwert reichende Skala bilden,
- während eines Schreibprozesses des gewünschten Musters eine Abfolge von Belichtungsintervallen (T1) erfolgt, wobei in jedem Belichtungsintervall die Blanking-Aperturen auf das Target (16) abgebildet werden und so eine entsprechende Vielzahl von Aperturenbildern (b1, bi0, bi1) erzeugt wird, wobei die Position der Aperturenbilder während eines Belichtungsintervalls relativ zum Target an der Position eines Pixels fest gehalten wird, aber zwischen den Belichtungsintervallen die Position der Aperturenbilder über das Target verschoben wird, und so die Vielzahl der Pixel auf dem Target belichtet wird, und
- die Aperturenbilder sich auf dem Target gegenseitig überlappen und die Aperturenbilder eine nominelle Breite (b) haben, die größer ist als der Abstand (e) zwischen Pixelpositionen benachbarter Aperturenbilder auf dem Target, und zwar um einen Überabtastungsfaktor (o), der größer als eins ist,

wobei das Berechnen des Belichtungsmusters umfasst:

(i) Bestimmen der diskreten Palette,
(ii) Bereitstellen des gewünschten Musters und Berechnen eines nominellen Belichtungsmusters als auf der Vielzahl von Pixelelementen definierte Rastergrafik (NP2, NP4), wobei das nominelle Belichtungsmuster dazu geeignet ist, eine nominelle Dosisverteilung auf dem Target zu erzeugen, die Konturlinien des gewünschten Musters ergibt und für jedes Pixelelement eine entsprechende nominelle Dosismenge (y) aufweist, und
(iii) Bestimmen eines diskreten Wertes (h) für jedes Pixelelement, der die nominalen Dosismenge (y) des jeweiligen Pixelelements approximiert, wobei der diskrete Wert aus der diskreten Palette ausgewählt wird,

wobei in Schritt (iii) das Bestimmen der diskreten Werte das Anwenden eines geordneten Ditherings unter Verwendung einer Dither-Matrix (T2, T4) mit einer vordefinierten Größe (d) umfasst.

**9.** Verfahren nach Anspruch 8, wobei die Dither-Matrix (T2, T4) eine Bayer-Matrix ist.

## Revendications

**1.** Procédé d'irradiation d'une cible avec un faisceau de rayonnement énergétique formé par des particules chargées électriquement, pour inscrire un motif souhaité sur ladite cible, comprenant les étapes suivantes

- fournir un dispositif de définition de motif (4) ayant une pluralité d'ouvertures (24) transparentes audit rayonnement,
- éclairer ledit dispositif de définition de motif au moyen d'un faisceau large d'éclairage (lb), qui traverse le dispositif de définition de motif à travers lesdites ouvertures, formant ainsi un faisceau modélisé (pb) constitué d'une pluralité correspondante de faisceaux (51),
- former ledit faisceau modélisé en une image à motifs (pm) sur l'emplacement de la cible (17), ladite image à motifs comprenant les images (b1) d'au moins une partie de la pluralité d'ouvertures couvrant un nombre de pixels de motif (px), c'est-à-dire de positions d'images des ouvertures, sur la cible,
au cours d'une séquence d'intervalles d'exposition, chacune des ouvertures étant commandée sélectivement de manière à transmettre des doses respectives aux pixels de motif (px), ci-après aussi dits pixels simplement, sur lesquels l'ouverture respective est imagée, lesdites doses (y) étant sélectionnées en fonction du motif souhaité, chaque pixel étant associé à une dose nominale (y) en fonction du motif souhaité,
- générer un mouvement relatif entre ladite cible (16) et le dispositif de définition de motif (4) produisant un mouvement graduel de ladite image à motifs sur la cible le long d'une trajectoire sur une région (r1, Rr) où une exposition au faisceau doit être effectuée, ladite trajectoire étant composée de sections qui s'étendent le long d'une direction de balayage (sd), lesdites sections correspondant à des bandes d'exposition (s11, s12, s13 ; s20, s21, s22) couvrant ladite région lors d'expositions séquentielles,

les bandes d'exposition (s11, s12, s13 ; s20, s21, s22) se chevauchent mutuellement en étant situées à différents décalages transversaux le long d'une direction (Y) transversale à la direction de balayage, de sorte que chaque zone de ladite région est exposée par au moins deux zones différentes de l'image à motifs à différents décalages transversaux (Y1),

- calculer une dose corrigée (y') pour chaque pixel, par un système électronique de traitement de l'information sur les motifs (18), en divisant la valeur de la dose nominale (y) par un facteur de correction (q), **caractérisé en ce que** le même facteur de correction (q) est utilisé avec des pixels écrits par des faisceaux situés à des positions qui ne diffèrent que par lesdits décalages transversaux (Y1) des bandes qui se chevauchent, tandis que le facteur de correction (q) varie entre les groupes de pixels qui diffèrent par un décalage qui ne correspond pas à un décalage transversal (Y1) des bandes qui se chevauchent.

2. Procédé de la revendication 1, dans lequel, au cours de l'étape de calculer une dose corrigée pour chaque pixel,

- une densité de courant disponible au niveau du pixel respectif est déterminée, ladite densité de courant disponible maximale étant déterminée comme la densité de courant actuelle du faisceau d'éclairage rayonné à travers l'ouverture correspondant au pixel respectif,
- ledit facteur de correction (q) du pixel respectif est calculé comme le rapport entre ladite densité de courant disponible et la densité de courant minimale dans l'ensemble du champ de la matrice de faisceaux, et
- la moyenne des facteurs de correction (q) est calculée pour les pixels situés à des positions qui ne diffèrent que par les décalages transversaux (Y1) des bandes qui se chevauchent.

3. Procédé de la revendication 1 ou 2, comprenant en outre

- la renormalisation multiplicative des facteurs de correction (q),

en utilisant un facteur de renormalisation choisi de telle sorte que l'une de la plus grande valeur et de la plus petite valeur des facteurs de correction soit renormalisée à 1.

4. Procédé de l'une quelconque des revendications 1 à 3, dans lequel l'étape de calculer la dose corrigée pour chaque pixel comprend le calcul, pour chaque pixel d'une rangée de pixels parallèle à la direction de balayage dans une bande d'exposition respective, des quantités de dose corrigées (y') en divisant les valeurs des quantités de dose par un facteur de correction de rangée (*q*), ledit facteur de correction de rangée étant appliqué uniformément à tous les pixels d'une rangée de pixels.

5. Procédé de la revendication 4, dans lequel le facteur de correction de rangée (q) est calculé pour une rangée respective de pixels sur la base des valeurs de la dose actuelle rayonnée à travers une série d'ouvertures, cette série d'ouvertures contenant toutes les ouvertures à l'intérieur du dispositif de définition de motif (4) qui transmettent des quantités de dose à la rangée respective de pixels, le facteur de correction de rangée (q) d'une rangée de pixels est calculé comme le rapport entre la dose de courant actuelle d'une ouverture, moyennée sur la série d'ouvertures correspondante, et une valeur de dose de courant nominale supposée constante sur la pluralité d'ouvertures (24) du dispositif de définition de motif (4).

6. Procédé de l'une des revendications 1 à 5, dans lequel ladite région (Rr) où une exposition au faisceau doit être effectuée est composée d'une pluralité de pixels de motif (px) disposés de manière régulière, ladite région ayant une largeur totale (Ry) mesurée dans ladite direction de balayage (sd), lesdites bandes d'exposition dans ladite région étant sensiblement parallèles les unes aux autres le long de ladite direction de balayage et ayant des largeurs uniformes (y0) mesurées dans ladite direction de balayage.

7. Procédé de la revendication 6, dans lequel les bandes d'exposition (s11, s12, s13 ; s20, s21, s22) se chevauchent mutuellement, la position des bandes différant par un décalage transversal (Y1) dans une direction à travers la direction de balayage, les facteurs de correction des rangées de pixels étant moyennés sur les rangées de pixels qui sont décalées les unes par rapport aux autres par ledit décalage transversal (Y1).

8. Procédé de la revendication 1, comprenant le calcul d'un modèle d'exposition adapté à l'exposition du motif souhaité sur une cible (16) en utilisant ledit dispositif de définition de motif (4) pour écrire ledit motif souhaité en exposant une multitude de pixels (px) à l'intérieur de ladite région (r1, Rr) sur la cible,

dans lequel, lors de l'exposition du motif souhaité sur une cible :

- dans ledit dispositif de définition de motif, ladite pluralité d'ouvertures d'obturation (24, 33, 43) est disposée selon un arrangement prédéterminé définissant les positions mutuelles des ouvertures d'obturation, chaque ouverture d'obturation étant sélectivement réglable au regard d'une valeur de dose à exposer à travers l'ouverture d'obturation respective sur une image d'ouverture correspondante sur la cible pendant un intervalle d'exposition respectif, ladite valeur de dose prenant une valeur respective conformément à une palette discrète, ladite palette discrète comprenant un certain nombre de valeurs de gris (h) formant une échelle allant d'une valeur minimale à une valeur maximale,

- au cours d'un processus d'écriture dudit motif souhaité, une séquence d'intervalles d'exposition (T1) est effectuée, dans chaque intervalle d'exposition les ouvertures d'obturation étant imagées sur la cible (16), générant ainsi une pluralité correspondante d'images d'ouverture (b1, bi0, bi1), la position des images d'ouverture étant maintenue fixe par rapport à la cible à la position d'un pixel pendant un intervalle d'exposition, mais entre les intervalles d'exposition, la position des images d'ouverture est déplacée sur la cible, ainsi exposant la multitude de pixels sur la cible, et

- les images d'ouverture se chevauchent mutuellement sur la cible, et les images d'ouverture ont une largeur nominale (b) supérieure à la distance (e) entre les positions des pixels des images d'ouverture voisines sur la cible, avec un facteur de suréchantillonnage (o) supérieur à un,

dans lequel le calcul du modèle d'exposition comprend

(i) déterminer la palette discrète,
(ii) fournir le motif souhaité et calculer un motif d'exposition nominal sous forme de graphiques matriciels (NP2, NP4) définis sur la multitude d'éléments de pixels, ledit motif d'exposition nominal étant adapté à la création d'une distribution de dose nominale sur la cible réalisant les lignes de contour du motif souhaité et comprenant pour chaque élément de pixel une quantité de dose nominale respective (y), et
(iii) déterminer, pour chaque élément de pixel, une valeur discrète (h) qui se rapproche de la dose nominale (y) de l'élément de pixel respectif, cette valeur discrète étant sélectionnée dans la palette discrète,

la détermination des valeurs discrètes à l'étape (iii) comprenant l'utilisation d'un tramage ordonné à l'aide d'une matrice de tramage (T2, T4) d'une taille prédéfinie (d).

**9.** Procédé de la revendication 8, dans laquelle la matrice de tramage (T2, T4) est une matrice de Bayer.

Fig. 1
(prior art)

Fig. 2
(prior art)

Fig. 3
(prior art)

Fig. 4
(prior art)

Fig. 5
(prior art)

Fig. 6A

C3

Nb

bi0

$e$=b

$o$=2

Fig. 6B

C4

Nb

$e$=b/2

bi1

b

X

$L_G$

$L_G$

pm

t=0

T1

p11

t=1

T1

p21

t=2

t

p31

Fig. 7
(prior art)

Fig. 8A

Fig. 8B

62

64

65

60

Fig. 9

Fig. 11A

67

66

68

70

69

62

Fig. 11B

Fig. 11C

Fig. 10A

Fig. 10B

Fig. 10C

Fig. 10D

$\alpha$ [%]

| Y [nm] \ X [nm] | | | | | | | | |
|---|---|---|---|---|---|---|---|
| 3.65 | 2.96 | 2.49 | 1.98 | 1.0 | -0.44 | -1.85 | -3.24 |
| 3.68 | 3.12 | 2.64 | 2.01 | 1.14 | -0.31 | -2.03 | -2.94 |
| 3.42 | 3.06 | 2.69 | 2.0 | 0.79 | -0.73 | -1.57 | -2.76 |
| 2.98 | 2.72 | 2.32 | 1.77 | 0.87 | -0.97 | -1.57 | -2.77 |
| 2.28 | 2.11 | 1.84 | 1.42 | 0.32 | -0.67 | -2.37 | -3.19 |
| 1.43 | 1.04 | 1.07 | 0.9 | -0.02 | -0.82 | -1.94 | -3.78 |
| 0.55 | 0.26 | 0.28 | 0.16 | -0.93 | -1.61 | -2.62 | -4.42 |
| 0.02 | -0.34 | -0.66 | -0.88 | -2.15 | -2.98 | -4.2 | -6.21 |

Mp

Fig. 12

160

PDATA

161

RAST

162

ASSIGN

163

CORR1

164

QUANT

165

CORR2

166

PPACK

PBUF

170

Fig. 13

Fig. 14

cfg1         cfg2         cfg3         cfg4         cfg5

Fig. 15

Fig. 26

B2

| 1 | 3 |
|---|---|
| 4 | 2 |

Fig. 17A

T2

| 1/8 | 5/8 |
|-----|-----|
| 7/8 | 3/8 |

Fig. 17B

NP2

| 0 | 0.5 | 1 | 1 | 1 | 1 | 0.1 | 0 |
|---|-----|---|---|---|---|-----|---|
| 0 | 0.5 | 1 | 1 | 1 | 1 | 0.1 | 0 |
| 0 | 0.5 | 1 | 1 | 1 | 1 | 0.1 | 0 |
| 0 | 0.5 | 1 | 1 | 1 | 1 | 0.1 | 0 |
| 0 | 0.5 | 1 | 1 | 1 | 1 | 0.1 | 0 |
| 0 | 0.5 | 1 | 1 | 1 | 1 | 0.1 | 0 |
| 0 | 0.5 | 1 | 1 | 1 | 1 | 0.1 | 0 |
| 0 | 0.5 | 1 | 1 | 1 | 1 | 0.1 | 0 |

TP2

| 1/8 | 5/8 | 1/8 | 5/8 | 1/8 | 5/8 | 1/8 | 5/8 |
|-----|-----|-----|-----|-----|-----|-----|-----|
| 7/8 | 3/8 | 7/8 | 3/8 | 7/8 | 3/8 | 7/8 | 3/8 |
| 1/8 | 5/8 | 1/8 | 5/8 | 1/8 | 5/8 | 1/8 | 5/8 |
| 7/8 | 3/8 | 7/8 | 3/8 | 7/8 | 3/8 | 7/8 | 3/8 |
| 1/8 | 5/8 | 1/8 | 5/8 | 1/8 | 5/8 | 1/8 | 5/8 |
| 7/8 | 3/8 | 7/8 | 3/8 | 7/8 | 3/8 | 7/8 | 3/8 |
| 1/8 | 5/8 | 1/8 | 5/8 | 1/8 | 5/8 | 1/8 | 5/8 |
| 7/8 | 3/8 | 7/8 | 3/8 | 7/8 | 3/8 | 7/8 | 3/8 |

| 0 | 0 | 1 | 1 | 1 | 1 | 0 | 0 |
|---|---|---|---|---|---|---|---|
| 0 | 1 | 1 | 1 | 1 | 1 | 0 | 0 |
| 0 | 0 | 1 | 1 | 1 | 1 | 0 | 0 |
| 0 | 1 | 1 | 1 | 1 | 1 | 0 | 0 |
| 0 | 0 | 1 | 1 | 1 | 1 | 0 | 0 |
| 0 | 1 | 1 | 1 | 1 | 1 | 0 | 0 |
| 0 | 0 | 1 | 1 | 1 | 1 | 0 | 0 |
| 0 | 1 | 1 | 1 | 1 | 1 | 0 | 0 |

QP2

Fig. 16

**B4**

| 14 | 3 | 10 | 7 |
|----|----|----|----|
| 2 | 15 | 5 | 12 |
| 11 | 8 | 13 | 4 |
| 6 | 9 | 1 | 16 |

**Fig. 19A**

**Fig. 19B**

T4 → $\frac{1}{32}$ x

| 27 | 5 | 19 | 13 |
|----|----|----|----|
| 3 | 29 | 9 | 23 |
| 21 | 15 | 25 | 7 |
| 11 | 17 | 1 | 31 |

**NP4**

| 0 | 0.5 | 1 | 1 | 1 | 1 | 0.1 | 0 |
|---|-----|---|---|---|---|-----|---|
| 0 | 0.5 | 1 | 1 | 1 | 1 | 0.1 | 0 |
| 0 | 0.5 | 1 | 1 | 1 | 1 | 0.1 | 0 |
| 0 | 0.5 | 1 | 1 | 1 | 1 | 0.1 | 0 |
| 0 | 0.5 | 1 | 1 | 1 | 1 | 0.1 | 0 |
| 0 | 0.5 | 1 | 1 | 1 | 1 | 0.1 | 0 |
| 0 | 0.5 | 1 | 1 | 1 | 1 | 0.1 | 0 |
| 0 | 0.5 | 1 | 1 | 1 | 1 | 0.1 | 0 |

| 27 | 5 | 19 | 13 | 27 | 5 | 19 | 13 |
|----|----|----|----|----|----|----|----|
| 3 | 29 | 9 | 23 | 3 | 29 | 9 | 23 |
| 21 | 15 | 25 | 7 | 21 | 15 | 25 | 7 |
| 11 | 17 | 1 | 31 | 11 | 17 | 1 | 31 |
| 27 | 5 | 19 | 13 | 27 | 5 | 19 | 13 |
| 3 | 29 | 9 | 23 | 3 | 29 | 9 | 23 |
| 21 | 15 | 25 | 7 | 21 | 15 | 25 | 7 |
| 11 | 17 | 1 | 31 | 11 | 17 | 1 | 31 |

x $\frac{1}{32}$

**TP4**

| 0 | 2/3 | 1 | 1 | 1 | 1 | 0 | 0 |
|---|-----|---|---|---|---|-----|---|
| 0 | 1/3 | 1 | 1 | 1 | 1 | 1/3 | 0 |
| 0 | 2/3 | 1 | 1 | 1 | 1 | 0 | 0 |
| 0 | 1/3 | 1 | 1 | 1 | 1 | 1/3 | 0 |
| 0 | 2/3 | 1 | 1 | 1 | 1 | 0 | 0 |
| 0 | 1/3 | 1 | 1 | 1 | 1 | 1/3 | 0 |
| 0 | 2/3 | 1 | 1 | 1 | 1 | 0 | 0 |
| 0 | 1/3 | 1 | 1 | 1 | 1 | 1/3 | 0 |

**Fig. 18**

**QP4**

33

NP20

| 7.125 | 7.125 |
|---|---|
| | |
| 15 | 15 |

$\frac{1}{15}$ x $\quad$ 44.25/60

QP20

| 8 | 7 |
|---|---|
| | |
| 15 | 15 |

45/60 $\quad$ x $\frac{1}{15}$

Fig. 20

NP21

| 7.5 | 7.5 |
|---|---|
| | |
| 15 | 15 |

$\frac{1}{15}$ x $\quad$ 45/60

QP21

| 8 | 7 |
|---|---|
| | |
| 15 | 15 |

45/60 $\quad$ x $\frac{1}{15}$

Fig. 21

NP20

| | |
|---|---|
| 7.125 | 7.125 |

$\frac{1}{15}$ x — 44.25/60 —

| | |
|---|---|
| 15 | 15 |

DF22

| | |
|---|---|
| 1 | 0.930 |
| 0.992 | 0.958 |

DP22

| | |
|---|---|
| 7.125 | 6.625 |

$\frac{1}{15}$ x — 43/60 —

| | |
|---|---|
| 14.875 | 14.375 |

NQ22

| | |
|---|---|
| 8 | 7 |

— 45/60 — x $\frac{1}{15}$

| | |
|---|---|
| 15 | 15 |

Fig. 22

NP20

| | |
|---|---|
| 7.125 | 7.125 |

$\frac{1}{15}$ x — 44.25/60 —

| | |
|---|---|
| 15 | 15 |

DF23

| | |
|---|---|
| 0.972 | 0.972 |
| 0.972 | 0.972 |

DP23

| | |
|---|---|
| 6.926 | 6.926 |

$\frac{1}{15}$ x — 43/60 —

| | |
|---|---|
| 14.580 | 14.580 |

NQ23

| | |
|---|---|
| 7 | 7 |

— 43/60 — x $\frac{1}{15}$

| | |
|---|---|
| 14 | 15 |

Fig. 23

NP24

| | |
|---|---|
| 15 | 15 |
| 40/60 | |
| 5 | 5 |

$\frac{1}{15}$ x

DF24

| | |
|---|---|
| 0.875 | 0.975 |
| 0.975 | 0.875 |

DP24

| | |
|---|---|
| 13.125 | 14.625 |
| 37/60 | |
| 4.875 | 4.375 |

$\frac{1}{15}$ x

QP24

| | |
|---|---|
| 14 | 15 |
| 39/60 | |
| 5 | 5 |

x $\frac{1}{15}$

Fig. 24

NP25

| | |
|---|---|
| 15 | 15 |
| 40/60 | |
| 5 | 5 |

$\frac{1}{15}$ x

DF25

| | |
|---|---|
| 0.925 | 0.925 |
| 0.925 | 0.925 |

DP25

| | |
|---|---|
| 13.875 | 13.875 |
| 37/60 | |
| 4.625 | 4.625 |

$\frac{1}{15}$ x

QP25

| | |
|---|---|
| 14 | 14 |
| 37/60 | |
| 4 | 5 |

x $\frac{1}{15}$

Fig. 25

Fig. 27-1

Fig. 27-2

Fig. 28-1

Fig. 28-2

Fig. 29-1

Fig. 29-2

Fig. 30-1

Fig. 30-2

Fig. 31-1

Fig. 31-2

Fig. 32-1

Fig. 32-2

Fig. 33-1

Fig. 33-2

Fig. 34-1

Fig. 34-2

Fig. 35-1

Fig. 35-2

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 8546767 B
- US 8378320 B2
- US 6768125 B
- US 7781748 B
- US 6858118 B
- US 8198601 B2
- US 8222621 B

- US 7276714 B
- US 9053906 B2
- US 20160276131 A1
- US 20150347660 A1
- US 9495499 B
- US 9269543 B